(19)

Europäisches
Patentamt
European
Patent Office
Office européen
des brevets

(11)  **EP 2 007 012 B1**

(12)  **EUROPEAN PATENT SPECIFICATION**

(45) Date of publication and mention
of the grant of the patent:
**28.12.2011 Bulletin 2011/52**

(51) Int Cl.:
**H03H 7/01** (2006.01)

(21) Application number: **08252146.9**

(22) Date of filing: **20.06.2008**

(54) **Filter circuit, filter circuit device, multilayered circuit board, and circuit module each including the filter circuit**

Filterschaltung, Filterschaltungsvorrichtung, mehrschichtige Leiterplatte und Schaltungsmodul, alle mit der Filterschaltung

Circuit de filtre, dispositif à circuit de filtrage, carte de circuit multicouche et module de circuit comprenant le circuit de filtrage

(84) Designated Contracting States:
**DE ES FR GB NL**

(30) Priority: **22.06.2007 JP 2007165298**
**26.12.2007 JP 2007333601**
**16.04.2008 JP 2008106440**

(43) Date of publication of application:
**24.12.2008 Bulletin 2008/52**

(73) Proprietor: **TAIYO YUDEN CO., LTD.**
**Taito-ku**
**Tokyo 110 (JP)**

(72) Inventor: **Oshima, Schinpei**
**Tokyo, 110-005 (JP)**

(74) Representative: **Jackson, Richard Eric et al**
**Carpmaels & Ransford**
**One Southampton Row**
**London**
**WC1B 5HA (GB)**

(56) References cited:
**JP-A- 4 207 706        JP-A- 11 243 306**
**JP-A- 58 190 113      JP-A- 2005 136 836**
**US-A- 5 202 651**

**Description**

BACKGROUND OF THE INVENTION

1. Field of the Invention

The present invention relates to a band-pass type filter circuit having a wide passband, and also relates to a filter circuit device, a multilayered circuit board, and a circuit module, each of which includes the filter circuit.

2. Description of the Related Art

Recently, development of a wireless system employing a wide band has been studied. In the wireless system employing the wide band, a BPF (Band Pass Filter) for selectively passing a necessary signal and blocking an unnecessary signal is desired to be adaptable for matching over the wide band and to have a low insertion loss.

There are known filters intended for use over the wide band. For example, Japanese Unexamined Patent Application Publication No. 2005-295316 discloses a high-frequency ring filter which can freely change a fractional band and can realize a wide band characteristic, which has a small insertion loss and a group delay characteristic with a flat and constant passband, and which can provide sharp attenuation. It also discloses a wide-band band pass filter utilizing the high-frequency ring filter.

Also, Japanese Unexamined Patent Application Publication No. 2005-318428 discloses a filter device having a small size and providing a band pass characteristic of a wide band, and a circuit module including the filter device. More specifically, it discloses a filter device having a band pass characteristic that is provided by a first filter means which is constituted by a distributed constant circuit and which has a band elimination characteristic, and by a second filter means for attenuating a frequency band which is not higher than a lower attenuation pole frequency and not lower than a higher attenuation pole frequency in the band elimination characteristic of the first filter. In addition, a circuit module including such a filter device is disclosed.

Further, Japanese Unexamined Patent Application Publication No. 2007-068123 discloses a band pass filter which has a fractional band characteristic of 20% or more and has a small attenuation in the frequency band according to the UWB (Ultra Wide Band) standards. The band pass filter is constituted by a plurality of broadside-coupled coupling conductors, an input-side waveguide which comprises a ground conductor and a waveguide conductor and which receives an electric signal at one of the coupling conductors, and an output-side waveguide which comprises a ground conductor and a waveguide conductor and which outputs an electric signal from one of the coupling conductors.

The filters disclosed in Japanese Unexamined Patent Application Publication No. 2005-295316 and Japanese Unexamined Patent Application Publication No. 2005-318428 are wide band filters each employing a ring resonator. Those filters can be realized in a planar and simple structure, but a problem arises in that the filter has a bulky shape because a transmission line of one or more wavelengths is required to constitute one resonance circuit.

As a known method of realizing the band pass filter with small resonators, Japanese Unexamined Patent Application Publication No. 2007-068123 discloses a method using broadside coupled resonators. To realize a wider band with the disclosed method, however, coupling between the resonators needs to be extremely intensified and a high-precision process is essential as a necessary condition for that purpose. Further, because the disclosed method realizes one resonance circuit by two lines, a circuit scale is increased in comparison with a stab type resonator.

In addition, any of the above-described known methods is a method using a distributed constant circuit. Stated another way, there is not yet known an example of realizing a wide band filter in a frequency band of 3 to 10 GHz without using a distribution constant element.

JP58190113 discloses a bridged T-type equalizer circuit for radio communication systems which is made of distributed constant elements together with concentrated elements to provide a constant delay and compensate for quality loss in a transmission signal.

JP2005136836 discloses a multiplication oscillation circuit with realise a low cost and reduced size filter circuit and comprises a resonance element illustrated by an open stab element.

US5202651 discloses a band stop filter circuit made into MMIC and showing excellent signal transmission characteristics.

SUMMARY OF THE INVENTION

In view of the above-described problems, an object of the present invention is to provide a band-pass type filter circuit which has a small size and can realize a wide passband characteristic, and to provide a filter circuit device, a multilayered circuit board, and a circuit module, each of which includes the filter circuit.

According to the present invention, the above object can be achieved with a filter circuit comprising a first impedance element disposed in an input side, a second impedance element disposed in an output side, having an input end connected to an output end of the first impedance element, and made of the same component as that of the first impedance element, a distributed constant resonance circuit having one end connected to a junction between the output end of the first impedance element and the input end of the second impedance element, and a third impedance element having one end connected to the input end of the first impedance element and the other end connected to the output end of the second impedance element, wherein at least one of the first to third impedance elements is constituted by an element having a predetermined concentrated constant, and the other impedance elements are each constituted by an element having a predetermined distributed constant.

The present invention can provide not only a filter circuit adapted for an ultra wide band, but also a wide band filter circuit having a plurality of attenuation poles. Further, the attenuation poles can be set to frequencies of harmonic resonances that are generated by the distributed constant resonance circuit. As a result, a wide band filter circuit having a small size and various characteristics can be realized.

In comparison with the related art employing only a distributed constant circuit to constitute a resonator and a filter, the present invention is featured in realizing a filter circuit having a smaller size and a superior wide band characteristic, which have been difficult to realize with the related art, by optionally combining the distributed constant resonance circuit with an element having a concentrated constant and an element having a distributed constant.

Further, the present invention provides a filter circuit device wherein the above-described filter circuit is formed in a device member constituting a device body, a multilayered circuit board in which the above-described filter circuit is formed, and a circuit module in which the above-described filter circuit is formed. Thus, by using a novel method of combining a concentrated constant element and a distributed constant element with each other, a wide band filter circuit having such a small size as that not obtained in the past can be realized in a multilayered circuit part and a circuit board.

BRIEF DESCRIPTION OF THE DRAWINGS

Fig. 1 is a diagram of a filter circuit according to a first embodiment of the present invention;

Fig. 2 is a graph showing frequency characteristics of the filter circuit according to the first embodiment of the present invention;

Fig. 3 is a diagram of a filter circuit as a reference example for comparison with the present invention;

Fig. 4 is a graph showing frequency characteristics of the filter circuit as a reference example for comparison with the present invention;

Fig. 5 is a diagram for explaining one example of a theoretical analysis in the first embodiment of the present invention;

Fig. 6 is a diagram for explaining an even-mode equivalent circuit in one example of the theoretical analysis in the first embodiment of the present invention;

Fig. 7 is a diagram for explaining an odd-mode equivalent circuit in one example of the theoretical analysis in the first embodiment of the present invention;

Fig. 8 is a graph showing frequency characteristics of Example 1 in the first embodiment;

Fig. 9 is a graph showing frequency characteristics of Example 2 in the first embodiment;

Fig. 10 is a graph showing frequency characteristics of another Example in the first embodiment;

Fig. 11 is a graph showing frequency characteristics of still another Example in the first embodiment;

Fig. 12 is a diagram of a filter circuit according to a second embodiment of the present invention;

Fig. 13 is a graph showing frequency characteristics of the filter circuit according to the second embodiment of the present invention;

Fig. 14 is a diagram of a filter circuit according to a third embodiment of the present invention;

Fig. 15 is a graph showing frequency characteristics of the filter circuit according to the third embodiment of the present invention;

Fig. 16 is a diagram of a filter circuit according to a fourth embodiment of the present invention;

Fig. 17 is a graph showing frequency characteristics of the filter circuit according to the fourth embodiment of the present invention;

Fig. 18 illustrates one modification of a distributed constant resonance circuit in the present invention;

Fig. 19 illustrates another modification of the distributed constant resonance circuit in the present invention;

Fig. 20 illustrates still another modification of the distributed constant resonance circuit in the present invention;

Fig. 21 illustrates still another modification of the distributed constant resonance circuit in the present invention;

Fig. 22 illustrates another modification of the distributed constant resonance circuit in the present invention;

Fig. 23 is a diagram of a filter circuit according to a fifth embodiment of the present invention;

Fig. 24 is a graph showing frequency characteristics of the filter circuit according to the fifth embodiment of the present invention;

Fig. 25 is a diagram of a filter circuit according to a sixth embodiment of the present invention;

Fig. 26 is a graph showing frequency characteristics of the filter circuit according to the sixth embodiment of the present invention;

Fig. 27 is a diagram of a filter circuit according to a seventh embodiment of the present invention;

Fig. 28 is a graph showing frequency characteristics of the filter circuit according to the seventh embodiment of the present invention;

Fig. 29 is a diagram of a filter circuit according to an eighth embodiment of the present invention;

Fig. 30 is a graph showing frequency characteristics of the filter circuit according to the eighth embodiment of the present invention;

Fig. 31 is a diagram of a filter circuit according to a ninth embodiment of the present invention;

Fig. 32 is a graph showing frequency characteristics of the filter circuit according to the ninth embodiment of the present invention;

Fig. 33 is a diagram of a band pass filter according to a tenth embodiment of the present invention;

Fig. 34 is a graph showing frequency characteristics of the band pass filter according to the tenth embodiment of the present invention;

Fig. 35 is a diagram of a band pass filter according to an eleventh embodiment of the present invention;

Fig. 36 is a graph showing frequency characteristics of the band pass filter according to the eleventh embodiment of the present invention;

Fig. 37 is a perspective view showing an external appearance of a filter circuit device according to a twelfth embodiment of the present invention;

Fig. 38 is an explanatory view for explaining shapes and layout of conductor patterns of the filter circuit device according to the twelfth embodiment of the present invention;

Fig. 39 is an explanatory view for explaining shapes and layout of the conductor patterns of the filter circuit device according to the twelfth embodiment of the present invention;

Fig. 40 is an explanatory view for explaining shapes and layout of conductor patterns of the filter circuit device according to the twelfth embodiment of the present invention;

Fig. 41 is a diagram showing an equivalent circuit of the filter circuit device according to the twelfth embodiment of the present invention;

Fig. 42 is a graph showing frequency characteristics of the filter circuit device according to the twelfth embodiment of the present invention;

Fig. 43 is a side view showing, in a seeing-through way, a high-frequency wireless circuit module according to a thirteenth embodiment of the present invention; and

Fig. 44 is a block diagram showing an electric circuit of the high-frequency wireless circuit module according to the thirteenth embodiment of the present invention.

DESCRIPTION OF THE PREFERRED EMBODIMENTS

Embodiments of the present invention will be described below with reference to the drawings.

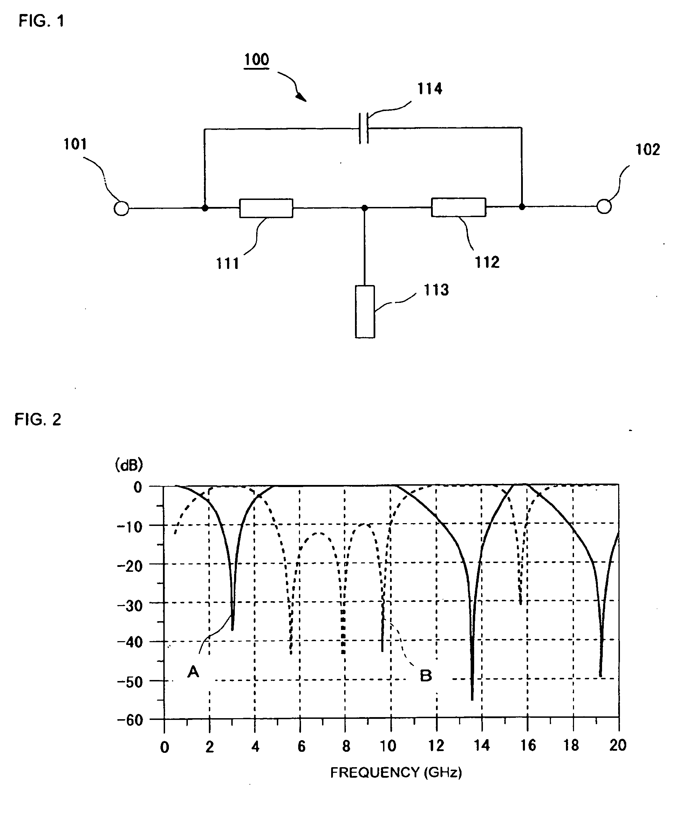

Fig. 1 shows a filter circuit according to a first embodiment of the present invention. A filter circuit 100 according to the first embodiment shown in Fig. 1, which represents a filter circuit of the present invention, comprises a first impedance element 111 having an input end connected to an input terminal 101, a second impedance element 112 having an input end connected to an output end of the first impedance element 111 and an output end connected to an output terminal 102 and made of the same component as that of the first impedance element 111, a distributed constant resonance circuit 113 having one end connected to a junction between the output end of the first impedance element 111 and the input end of the second impedance element 112, and a third impedance element 114 having one end connected to the input end of the first impedance element 111 and the other end connected to the output end of the second impedance element 112. In the first embodiment, the first impedance element 111 and the second impedance element 112 are each made of a distributed constant resonance circuit constituted by a transmission line which has a predetermined distributed constant. The distributed constant resonance circuit 113 is made of an open stub type resonance circuit constituted by a transmission line which has a predetermined distributed constant and is opened at the other end of the distributed constant resonance circuit 113. The third impedance element 114 is made of a capacitor having a predetermined concentrated constant.

Thus, the filter circuit 100 is a band-pass type filter circuit in which a wide band is realized by cancelling periodic attenuation poles that are in principle specific to the distributed-constant stub type resonance circuit serving as the distributed constant resonance circuit 113, and it has a very simple structure comprising one distributed-constant stub type resonance circuit, two transmission lines (i.e., very short transmission lines of about 1/10 wavelength), and one capacitor.

This first embodiment will be described below in connection with a filter circuit which is adapted for realizing a band pass filter having a wide frequency pass band of 3 - 10 GHz. In this first embodiment, therefore, the open stub type resonance circuit serving as the distributed constant resonance circuit 113 is set such that an electrical length is 180° and a characteristic impedance is 40 Ω at the resonance frequency of 6 GHz.

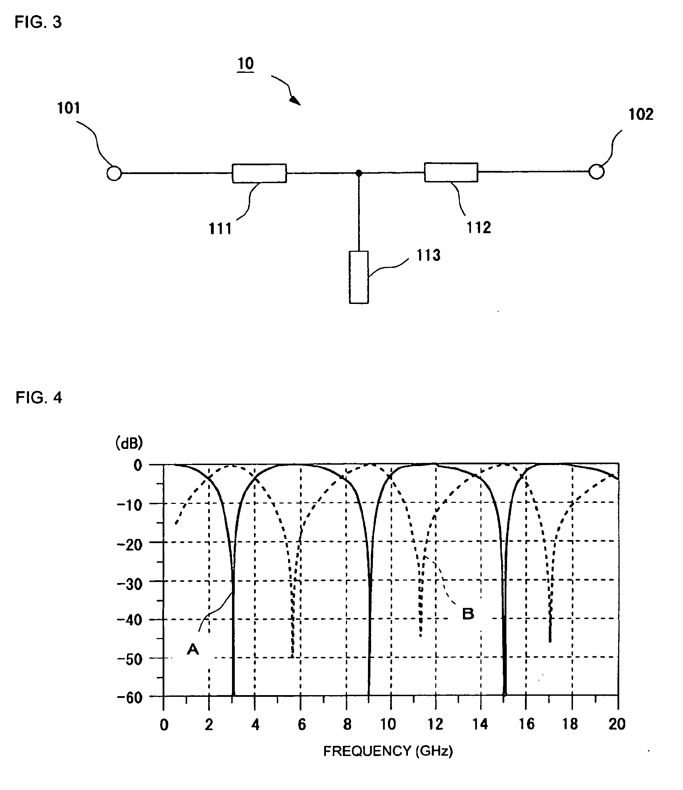

Fig. 3 shows a filter circuit as a reference example for comparison with the present invention. A filter circuit 10 as the reference example has a structure that the third impedance element 114 is removed from the filter circuit 100. In general, a distributed constant filter such as a laminated filter, like the filter circuit 10 shown in Fig. 3, is mainly constituted by a method using, as a basis, a stub type resonance circuit with a 1/4 or 1/2 wavelength. In the distributed-constant stub type resonance circuit (distributed constant resonance circuit 113), however, because an impedance periodically changes as a tangent (tan) function depending on frequency, an attenuation pole (impedance = 0) and a passband (impedance = infinitive) are alternately generated at integer-time frequencies. Due to such a periodicity, it has been impossible in principle to constitute a filter circuit having an ultra wide band characteristic by using the distributed-constant stub type resonance circuit. More specifically, as seen from frequency characteristic graph of Fig. 4, attenuation poles are generated at frequencies three and five times 3 GHz. Thus, such periodic appearance of the attenuation poles basically impedes realization of a wide band. In Fig. 4, the horizontal axis represents frequency, and the vertical axis represents amounts of attenuation and reflection. Also, a characteristic curve A and a characteristic curve B in Fig. 4 represent a band pass characteristic and a reflection characteristic, respectively. Further, the distributed-constant stub type resonance circuit serving as the distributed constant resonance circuit 113 in the filter circuit 10 of Fig. 3 has such a characteristic that an electrical length is 180° and a characteristic impedance is 40 Ω at the frequency of 6 GHz.

Fig. 2 shows a characteristic example of the filter circuit 100 according to the first embodiment. In Fig. 2, the horizontal axis represents frequency, and the vertical axis represents amounts of attenuation and reflection. Also, a characteristic curve A and a characteristic curve B in Fig. 2 represent a band pass characteristic and a reflection characteristic, respectively. In the filter circuit 100 according to the first embodiment, as seen from Fig. 2, the attenuation pole at 9 GHz among the periodic attenuation poles specific to the stub type resonance circuit (distributed constant resonance circuit 113) disappears. It is also seen that the number of matching frequencies is increased to three. Stated another way, the filter circuit 100 can cancel the attenuation pole that is in principle specific to the distributed-constant stub type resonance circuit, and can widen a passband of the distributed-constant stub type resonance circuit by increasing the number of matching frequencies.

Conditions for generation of the attenuation pole can be easily determined by a theoretical analysis, and the position, etc. of the attenuation pole in the frequency characteristics of the filter circuit 100 can be adjusted by setting the constants of the impedance elements, etc. so as to satisfy the conditions.

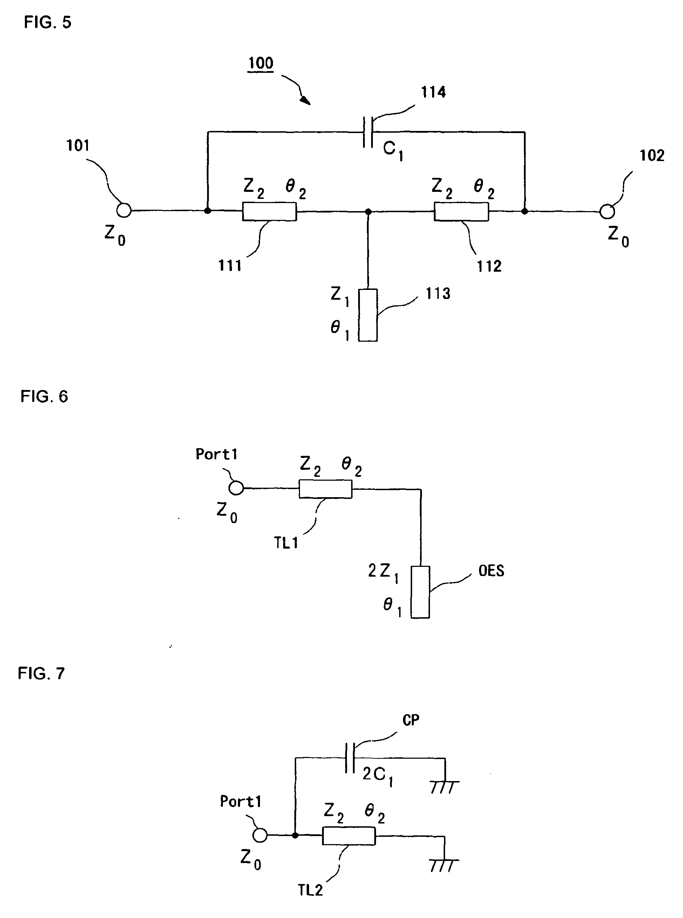

The following description is made of one example when the attenuation pole frequency and the matching frequency in the circuit shown in Fig. 1. In this example, it is assumed that, as shown in Fig. 5, each of the transmission lines forming the first impedance element 111 and the second impedance element 112 has a characteristic impedance $Z_2$ and an electrical length $\theta_2$, that the distributed constant resonance circuit 113 is made of a 1/2-wavelength open stub and has a characteristic impedance $Z_1$ and an electrical length $\theta_1$, and that the fourth impedance element 114 is made of a capacitor with a capacitance $C_1$. Also, it is assumed that a characteristic impedance in each of the input terminal side and the output terminal side is $Z_0$.

Herein, since the circuits shown in Figs. 1 and 5 have a bilaterally symmetric circuit configuration, an even-odd mode analysis can be performed. Fig. 6 shows an even-mode equivalent circuit, and Fig. 7 shows an odd-mode equivalent circuit.

The even-mode equivalent circuit, shown in Fig. 6, comprises a transmission line TL1 having one end connected to a terminal Port1, and a 1/2-wavelength open stub OES connected to the other end of the transmission line TL1. In this equivalent circuit, the terminal Port1 has a characteristic impedance $Z_0$, the transmission line TL1 has a characteristic impedance $Z_2$ and an electrical length $\theta_2$, and the open stub OES has a characteristic impedance $2Z_1$ and an electrical length $\theta_1$.

The odd-mode equivalent circuit, shown in Fig. 7, comprises a transmission line TL2 having one end connected to the terminal Port1 and the other end grounded, and a capacitor CP having one end connected to the terminal Port1 and the other end grounded. In this equivalent circuit, the terminal Port1 has the characteristic impedance $Z_0$, the transmission line TL2 has a characteristic impedance $Z_2$ and an electrical length $\theta_2$, and the capacitor CP has a capacitance $2C_1$.

From the even-mode equivalent circuit shown in Fig. 6, an input impedance $Z_{even}$ and a reflection coefficient $\Gamma_{even}$ in the even mode are expressed by the following formulae (1) and (2), respectively:

$$Z_{even} = jZ_2 \frac{Z_2 \tan\theta_1 \tan\theta_2 - 2Z_1}{Z_2 \tan\theta_1 + 2Z_1 \tan\theta_2} \quad \cdots (1)$$

$$\Gamma_{even} = \frac{Z_{even} - Z_0}{Z_{even} + Z_0}$$

$$= \frac{2Z_1 \cot\theta_1(Z_2 - jZ_0 \tan\theta_2) - Z_2(jZ_0 + Z_2 \tan\theta_2)}{2Z_1 \cot\theta_1(Z_2 + jZ_0 \tan\theta_2) - Z_2(-jZ_0 + Z_2 \tan\theta_2)} \quad \cdots (2)$$

Also, an input impedance $Z_{odd}$ and a reflection coefficient $\Gamma_{odd}$ in the odd mode are expressed by the following formulae (3) and (4), respectively:

$$Z_{odd} = \frac{1}{2j\omega C_1 + \dfrac{1}{jZ_2 \tan\theta_2}} \quad \cdots (3)$$

$$\Gamma_{odd} = \frac{Z_{odd} - Z_0}{Z_{odd} + Z_0}$$

$$= \frac{Z_2(j + 2\omega C_1 Z_0) - Z_0 \cot\theta_2}{jZ_2 - 2\omega C_1 Z_0 Z_2 + Z_0 \cot\theta_2} \quad \cdots (4)$$

From the above formulae (2) and (4), $S_{11}$ and $S_{21}$ can be derived as expressed by the following formulae (5) and (6), respectively:

$$S_{11} = \frac{\Gamma_{even} + \Gamma_{odd}}{2} \quad \cdots (5)$$

$$S_{21} = \frac{\Gamma_{even} - \Gamma_{odd}}{2} \quad \cdots (6)$$

Accordingly, the matching frequency in each of the circuits shown in Figs. 1 and 5 is determined based on $\Gamma_{even} = -\Gamma_{odd}$, i.e., a condition satisfying $S_{11} = 0$. Further, the attenuation pole frequency in each of the circuits shown in Figs. 1 and 5 is determined based on $\Gamma_{even} = \Gamma_{odd}$, i.e., a condition satisfying $S_{21} = 0$.

As a matter of course, in later-described circuits having the circuit configuration other than that of Fig. 1, the attenuation pole frequency and the matching frequency in each of those circuits can also be determined by executing the theoretical analysis in the even and odd modes as described above.

Example 1

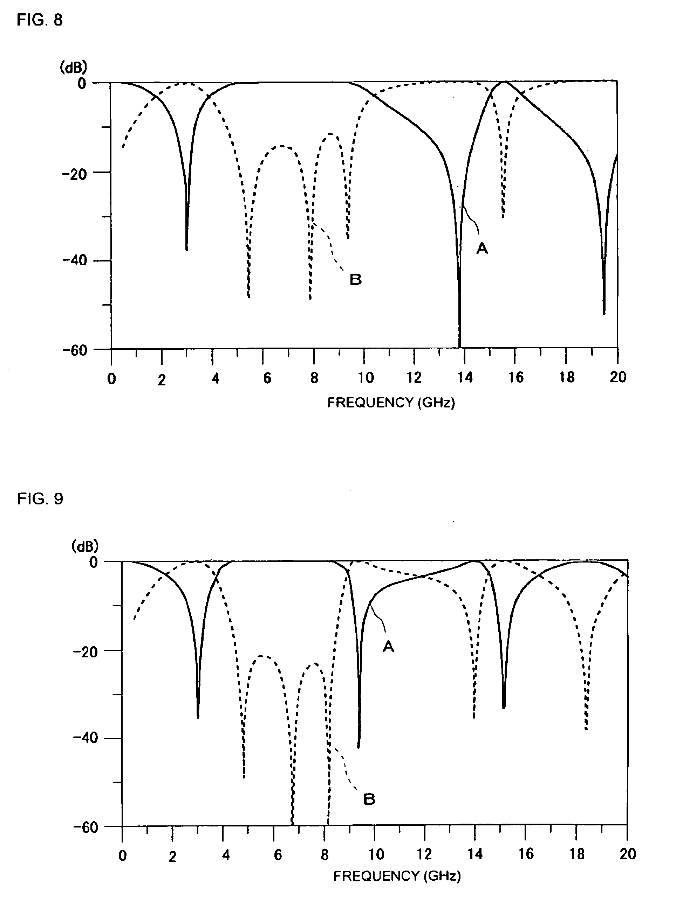

Fig. 8 shows frequency characteristics of Example 1. In Fig. 8, the horizontal axis represents frequency, and the vertical axis represents amounts of attenuation and reflection. Also, a characteristic curve A and a characteristic curve B in Fig. 8 represent a band pass characteristic and a reflection characteristic, respectively. In Example 1, each of the transmission lines constituting the first impedance element 111 and the second impedance element 112 has a characteristic impedance of 30 Ω and an electrical length of 18° at the frequency of 6 GHz. The transmission line constituting the distributed constant resonance circuit 113 has a characteristic impedance of 40 Ω and an electrical length of 180° at the frequency of 6 GHz. The capacitor constituting the third impedance element 114 has a capacitance of 0.68 pF.

Example 2

Fig. 9 shows frequency characteristics of Example 2. In Fig. 9, the horizontal axis represents frequency, and the vertical axis represents amounts of attenuation and reflection. Also, a characteristic curve A and a characteristic curve B in Fig. 9 represent a band pass characteristic and a reflection characteristic, respectively. In Example 2, each of the transmission lines constituting the first impedance element 111 and the second impedance element 112 has a characteristic impedance of 32 Ω and an electrical length of 56° at the frequency of 6 GHz. The transmission line constituting the distributed constant resonance circuit 113 has a characteristic impedance of 40 Ω and an electrical length of 180° at the frequency of 6 GHz. The capacitor constituting the third impedance element 114 has a capacitance of 0.14 pF.

The position of the attenuation pole in the lower frequency side, i.e., the position of the attenuation pole at 3 GHz in the frequency characteristics of Figs. 8 and 9, depends only on the length of the open stub type resonance circuit constituting the distributed constant resonance circuit 113. Also, the attenuation pole in the higher frequency side, i.e., the attenuation pole present in the higher frequency side than 8 GHz in the frequency characteristics of Figs. 8 and 9, can be controlled by the transmission lines constituting the first impedance element 111 and the second impedance element 112 and the capacitor constituting the third impedance element 114. For example, by setting the electrical length of each of the transmission lines constituting the first impedance element 111 and the second impedance element 112 to a larger value and the capacitance of the capacitor constituting the third impedance element 114 to a smaller value, the attenuation pole in the higher frequency side is shifted toward the lower frequency side. Also, by setting the electrical length of each of the transmission lines constituting the first impedance element 111 and the second impedance element 112 to a smaller value and the capacitance of the capacitor constituting the third impedance element 114 to a larger value, the attenuation pole in the higher frequency side is shifted toward the even higher frequency side.

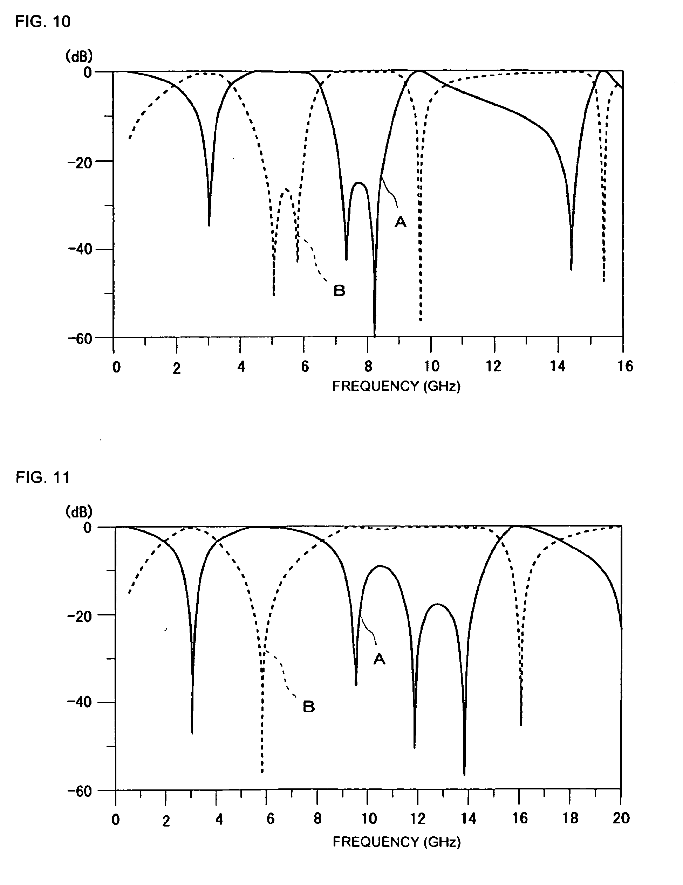

Further, as seen from frequency characteristics shown in Figs. 10 and 11, two or more attenuation poles adjacent to each other can be produced in the higher frequency side. Also in such a case, the position of the attenuation pole in the lower frequency side depends only on the length of the open stub type resonance circuit constituting the distributed constant resonance circuit 113. In addition, the number and positions of the attenuation poles in the higher frequency side depend on the characteristic impedance and the electrical length of each of the transmission lines constituting the first impedance element 111 and the second impedance element 112, the characteristic impedance of the open stub type resonance circuit constituting the distributed constant resonance circuit 113, and the capacitance of the capacitor constituting the third impedance element 114.

A second embodiment of the present invention will be described below.

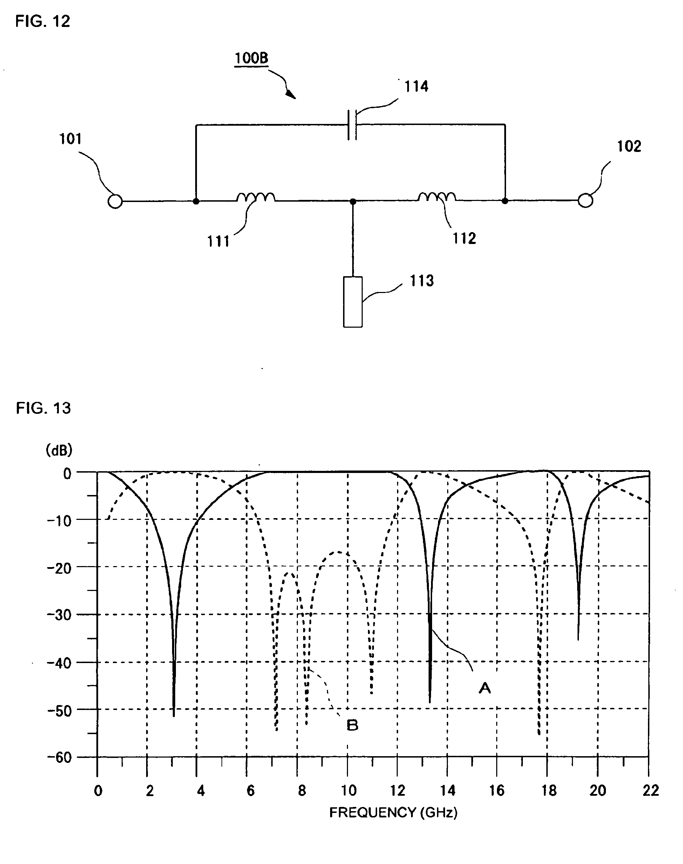

Fig. 12 is a diagram of a filter circuit according to the second embodiment of the present invention, and Fig. 13 is a graph showing frequency characteristics of the filter circuit according to the second embodiment. The second embodiment will be described in connection with a filter circuit which is adapted for realizing a band pass filter having a wide frequency passband of 3 - 10 GHz.

A filter circuit 100B shown in Fig. 12 comprises a first impedance element 111 having an input end connected to an input terminal 101, a second impedance element 112 having an input end connected to an output end of the first impedance element 111 and an output end connected to an output terminal 102 and made of the same component as that of the first impedance element 111, a distributed constant resonance circuit 113 having one end connected to a junction between the output end of the first impedance element 111 and the input end of the second impedance element 112, and a third impedance element 114 having one end connected to the input end of the first impedance element 111 and the other end connected to the output end of the second impedance element 112.

In the second embodiment, the first impedance element 111 and the second impedance element 112 are each made of an inductor having a predetermined concentrated constant. The distributed constant resonance circuit 113 is made of an open stub type resonance circuit constituted by a transmission line which has a predetermined distributed constant and is opened at the other end of the distributed constant resonance circuit 113. The third impedance element 114 is made of a capacitor having a predetermined concentrated constant.

As in the filter circuit 100 of the first embodiment, the filter circuit 100B of the second embodiment is also a band-pass type filter circuit in which a wide band is realized by cancelling periodic attenuation poles that are in principle specific to the distributed-constant stub type resonance circuit serving as the distributed constant resonance circuit 113, and it has a very simple structure comprising one distributed-constant stub type resonance circuit, two inductors, and one capacitor.

In this second embodiment, each of the inductors constituting the first and second impedance elements 111, 112 has an inductance of 0.35 nH. The transmission line constituting the distributed constant resonance circuit 113 has a characteristic impedance of 18 Ω and an electrical length of 18° at the frequency of 6 GHz. The capacitor constituting the third impedance element 114 has a capacitance of 0.54 pF.

With the above-described arrangement and setting, this second embodiment also realizes, as shown in Fig. 13, the band-pass type filter circuit having a wide frequency passband of 3 - 10 GHz.

Further, as in the first embodiment, conditions for generation of the attenuation pole can be easily determined by a theoretical analysis, and the position, etc. of the attenuation pole in the frequency characteristics of the filter circuit 100B can be adjusted by setting the constants of the impedance elements, etc. so as to satisfy the conditions.

A third embodiment of the present invention will be described below.

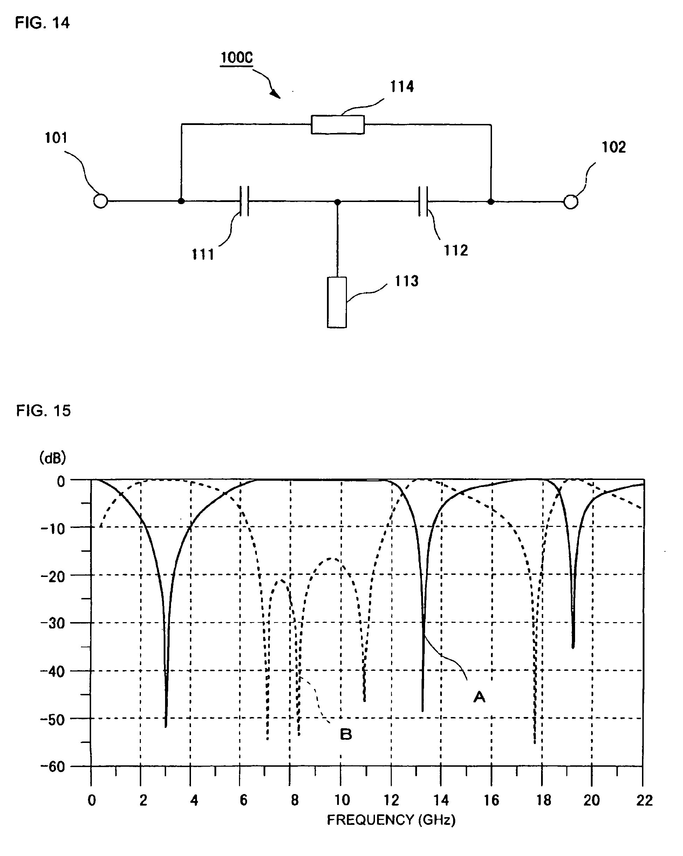

Fig. 14 is a diagram of a filter circuit according to the third embodiment of the present invention, and Fig. 15 is a graph showing frequency characteristics of the filter circuit according to the third embodiment. The third embodiment will be described in connection with a filter circuit which is adapted for realizing a band pass filter having a wide frequency passband of 3 - 10 GHz.

A filter circuit 100C shown in Fig. 14 comprises a first impedance element 111 having an input end connected to an input terminal 101, a second impedance element 112 having an input end connected to an output end of the first impedance element 111 and an output end connected to an output terminal 102 and made of the same component as that of the first impedance element 111, a distributed constant resonance circuit 113 having one end connected to a junction between the output end of the first impedance element 111 and the input end of the second impedance element 112, and a third impedance element 114 having one end connected to the input end of the first impedance element 111 and the other end connected to the output end of the second impedance element 112.

In the third embodiment, the first impedance element 111 and the second impedance element 112 are each made of a capacitor having a predetermined concentrated constant. The distributed constant resonance circuit 113 is made of an open stub type resonance circuit constituted by a transmission line which has a predetermined distributed constant and is opened at the other end of the distributed constant resonance circuit 113. The third impedance element 114 is made of a transmission line having a predetermined distributed constant.

As in the filter circuit 100 of the first embodiment, the filter circuit 100C of the third embodiment is also a band-pass type filter circuit in which a wide band is realized by cancelling periodic attenuation poles that are in principle specific to the distributed-constant stub type resonance circuit serving as the distributed constant resonance circuit 113, and it has a very simple structure comprising one distributed-constant stub type resonance circuit, two capacitors, and one distributed-constant type transmission line.

In this third embodiment, each of the capacitors constituting the first and second impedance elements 111, 112 has a capacitance of 1.14 pF. The transmission line constituting the distributed constant resonance circuit 113 has a characteristic impedance of 32.5 Ω and an electrical length of 180° at the frequency of 6 GHz. The transmission line constituting the third impedance element 114 has a characteristic impedance of 30 Ω and an electrical length of 36° at the frequency of 6 GHz.

With the above-described arrangement and setting, this third embodiment also realizes, as shown in Fig. 15, the band-pass type filter circuit having a wide frequency passband of 3 - 10 GHz.

Further, as in the first embodiment, conditions for generation of the attenuation pole can be easily determined by a theoretical analysis, and the position, etc. of the attenuation pole in the frequency characteristics of the filter circuit 100C can be adjusted by setting the constants of the impedance elements, etc. so as to satisfy the conditions.

A fourth embodiment of the present invention will be described below.

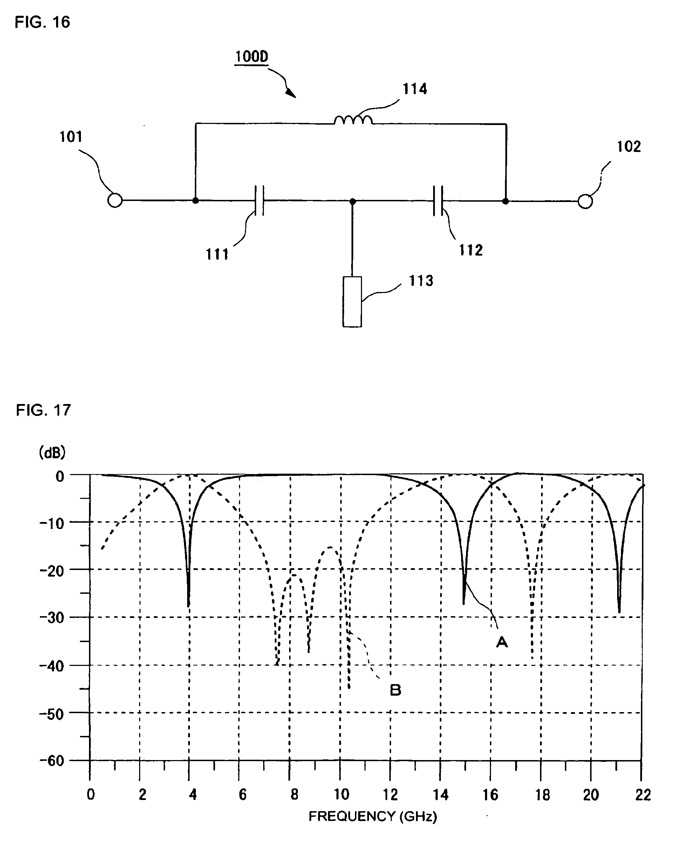

Fig. 16 is a diagram of a filter circuit according to the fourth embodiment of the present invention, and Fig. 17 is a graph showing frequency characteristics of the filter circuit according to the fourth embodiment. The fourth embodiment will be described in connection with a filter circuit which is adapted for realizing a band pass filter having a wide frequency passband of 4 - 14 GHz.

A filter circuit 100D shown in Fig. 16 comprises a first impedance element 111 having an input end connected to an input terminal 101, a second impedance element 112 having an input end connected to an output end of the first impedance element 111 and an output end connected to an output terminal 102 and made of the same component as that of the first impedance element 111, a distributed constant resonance circuit 113 having one end connected to a junction between the output end of the first impedance element 111 and the input end of the second impedance element 112, and a third impedance element 114 having one end connected to the input end of the first impedance element 111 and the other end connected to the output end of the second impedance element 112.

In the fourth embodiment, the first impedance element 111 and the second impedance element 112 are each made of a capacitor having a predetermined concentrated constant. The distributed constant resonance circuit 113 is made of an open stub type resonance circuit constituted by a transmission line which has a predetermined distributed constant and is opened at the other end of the distributed constant resonance circuit 113. The third impedance element 114 is made of an inductor having a predetermined concentrated constant.

As in the filter circuit 100 of the first embodiment, the filter circuit 100D of the fourth embodiment is also a band-pass type filter circuit in which a wide band is realized by cancelling periodic attenuation poles that are in principle specific to the distributed-constant stub type resonance circuit serving as the distributed constant resonance circuit 113, and it has a very simple structure comprising one distributed-constant stub type resonance circuit, two capacitors, and one inductor.

In this fourth embodiment, each of the capacitors constituting the first and second impedance elements 111, 112 has a capacitance of 1.416 pF. The transmission line constituting the distributed constant resonance circuit 113 has a characteristic impedance of 35.2 Ω and an electrical length of 180° at the frequency of 6 GHz. The inductor constituting the third impedance element 114 has an inductance of 0.42 nH.

With the above-described arrangement and setting, this fourth embodiment realizes, as shown in Fig. 17, the band-pass type filter circuit having a wide frequency passband of 4 - 14 GHz.

Further, as in the first embodiment, conditions for generation of the attenuation pole can be easily determined by a theoretical analysis, and the position, etc. of the attenuation pole in the frequency characteristics of the filter circuit 100D can be adjusted by setting the constants of the impedance elements, etc. so as to satisfy the conditions.

Next, modified embodiments of the present invention will be described.

Modifications of the distributed constant resonance circuit 113 are described herein.

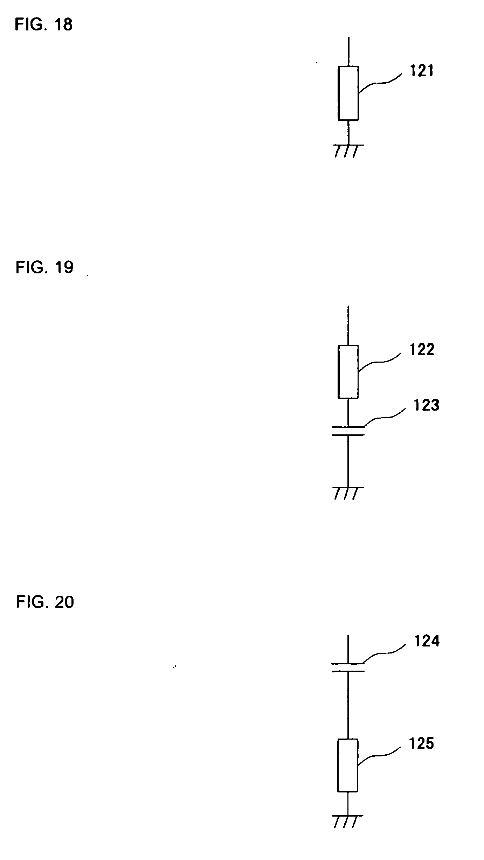

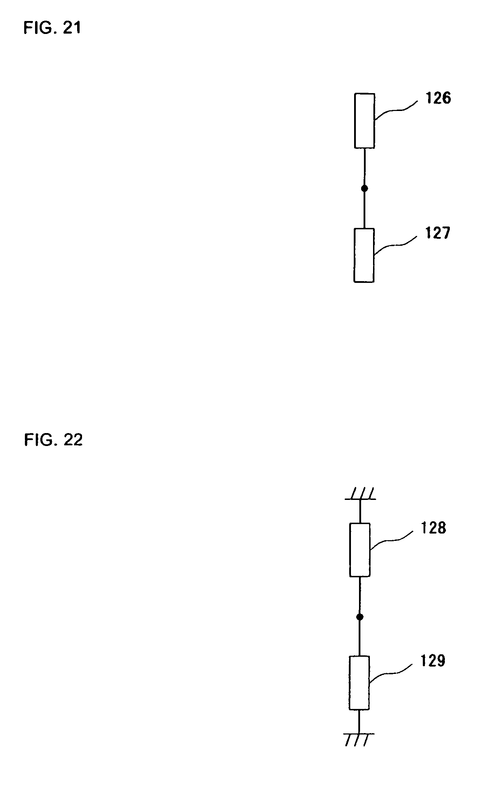

As modifications, the distributed constant resonance circuit 113 can be constituted, for example, as shown in Figs. 18-22. In the modification shown in Fig. 18, the distributed constant resonance circuit 113 is made of a short stub type resonance circuit constituted by a transmission line 121 which has a predetermined distributed constant and is grounded at the other end thereof. In the modification shown in Fig. 19, the distributed constant resonance circuit 113 is made of a transmission line 122 which has a predetermined distributed constant and is grounded at the other end thereof through a capacitor 123. In the modification shown in Fig. 20, the distributed constant resonance circuit 113 is made of a transmission line 125 which has a predetermined distributed constant and which is connected at one end thereof to a capacitor 124 and is grounded at the other end thereof. In the modification shown in Fig. 21, the distributed constant resonance circuit 113 is constituted by interconnecting respective one ends of two transmission lines 126 and 127, each of which has a predetermined distributed constant and is opened at the other end thereof. In the modification shown in Fig. 22, the distributed constant resonance circuit 113 is constituted by interconnecting respective one ends of two transmission lines (distributed constant resonance circuits) 128 and 129, each of which has a predetermined distributed constant and is grounded at the other end thereof.

A fifth embodiment of the present invention will be described below in relation to the case where the transmission line 121 shown in Fig. 18 is employed as the distributed constant resonance circuit 113.

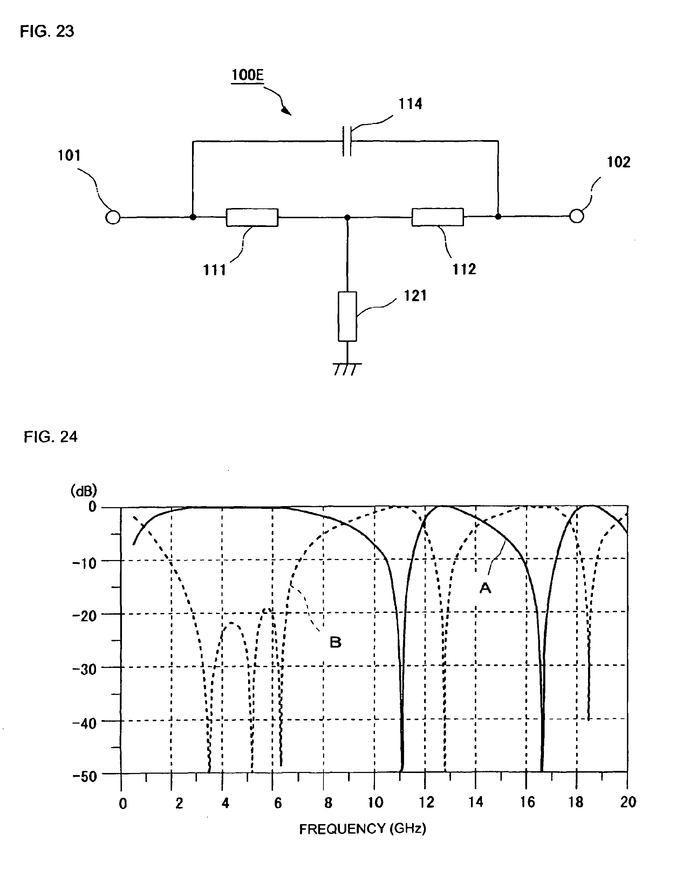

Fig. 23 is a diagram of a filter circuit according to the fifth embodiment of the present invention, and Fig. 24 is a graph showing frequency characteristics of the filter circuit according to the fifth embodiment. The fifth embodiment will be described in connection with a filter circuit which is adapted for realizing a band pass filter having a wide frequency passband of 3 - 10 GHz.

A filter circuit 100E shown in Fig. 23 comprises a first impedance element 111 having an input end connected to an input terminal 101, a second impedance element 112 having an input end connected to an output end of the first impedance element 111 and an output end connected to an output terminal 102 and made of the same component as that of the first impedance element 111, a distributed constant resonance circuit 121 having one end connected to a junction between the output end of the first impedance element 111 and the input end of the second impedance element 112, and a third impedance element 114 having one end connected to the input end of the first impedance element 111 and the other end connected to the output end of the second impedance element 112.

In the fifth embodiment, the first impedance element 111 and the second impedance element 112 are each made of a distributed constant resonance circuit constituted by a transmission line which has a predetermined distributed constant. The distributed constant resonance circuit 121 is made of a short stub type resonance circuit constituted by a transmission line which has a predetermined distributed constant and is grounded at the other end of the distributed constant resonance circuit 121. The third impedance element 114 is made of a capacitor having a predetermined concentrated constant.

The filter circuit 100E of the fifth embodiment is also a band-pass type filter circuit realizing a wide band, and it has a very simple structure comprising one distributed-constant stub type resonance circuit, two transmission lines, and one capacitor.

In this fifth embodiment, each of the transmission lines (distributed constant resonance circuits) constituting the first and second impedance elements 111, 112 has a characteristic impedance of 50 Ω and an electrical length of 180° at the frequency of 6 GHz. The transmission line constituting the distributed constant resonance circuit 121 has a characteristic impedance of 50 Ω and an electrical length of 20° at the frequency of 6 GHz. The capacitor constituting the third impedance element 114 has a capacitance of 0.85 pF.

With the above-described arrangement and setting, this fifth embodiment also realizes, as shown in Fig. 24, the band-pass type filter circuit having a wide frequency passband of 3 - 10 GHz.

Further, as in the first embodiment, conditions for generation of the attenuation pole can be easily determined by a theoretical analysis, and the position, etc. of the attenuation pole in the frequency characteristics of the filter circuit 100E can be adjusted by setting the constants of the impedance elements, etc. so as to satisfy the conditions.

A sixth embodiment of the present invention will be described below in relation to the case where the transmission line 122 and the capacitor 123, shown in Fig. 19, are employed as the distributed constant resonance circuit 113.

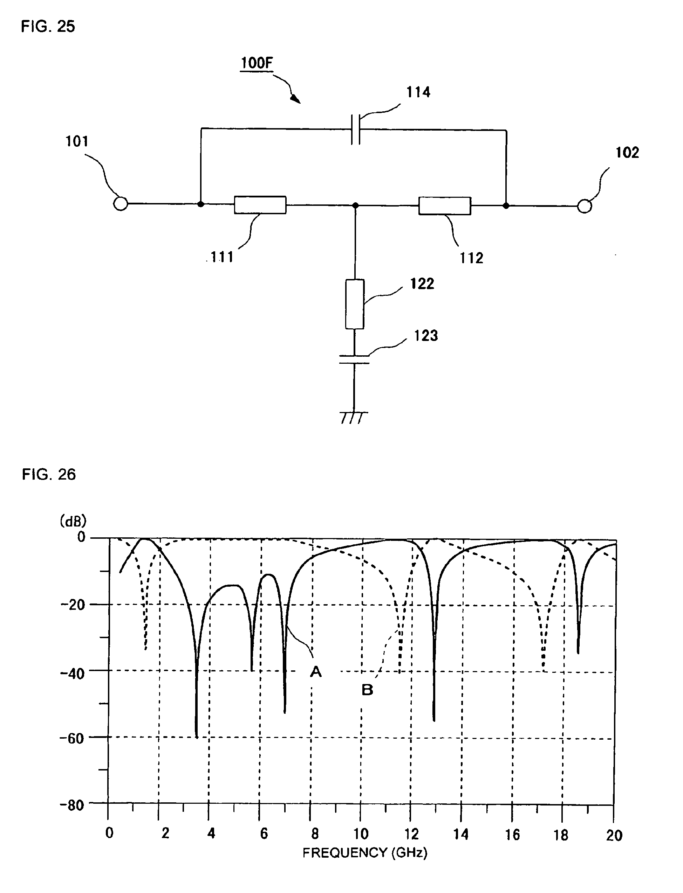

Fig. 25 is a diagram of a filter circuit according to the sixth embodiment of the present invention, and Fig. 26 is a graph showing frequency characteristics of the filter circuit according to the sixth embodiment. The sixth embodiment will be described in connection with a filter circuit which is adapted for realizing a band pass filter having a wide frequency passband of 7 - 13 GHz.

A filter circuit 100F shown in Fig. 25 comprises a first impedance element 111 having an input end connected to an input terminal 101, a second impedance element 112 having an input end connected to an output end of the first impedance element 111 and an output end connected to an output terminal 102 and made of the same component as that of the first impedance element 111, a transmission line 122 having one end connected to a junction between the output end of the first impedance element 111 and the input end of the second impedance element 112, a capacitor 123 having one end connected to the other end of the transmission line 122 and the other end grounded, and a third impedance element 114 having one end connected to the input end of the first impedance element 111 and the other end connected to the output end of the second impedance element 112.

In the sixth embodiment, the first impedance element 111 and the second impedance element 112 are each made of a distributed constant resonance circuit constituted by a transmission line which has a predetermined distributed constant. The third impedance element 114 is made of a capacitor having a predetermined concentrated constant.

The filter circuit 100F of the sixth embodiment is also a band-pass type filter circuit realizing a wide band, and it has a very simple structure comprising one distributed-constant stub type resonance circuit, two transmission lines, and two capacitors.

In this sixth embodiment, each of the transmission lines (distributed constant resonance circuits) constituting the first and second impedance elements 111, 112 has a characteristic impedance of 35 Ω and an electrical length of 18° at the frequency of 6 GHz. Of the transmission line 122 and the capacitor 123 both constituting the distributed constant resonance circuit 113, the transmission line 122 has a characteristic impedance of 50 Ω and an electrical length of 180° at the frequency of 6 GHz, and the capacitor 123 has a capacitance of 2 pF. The capacitor constituting the third impedance element 114 has a capacitance of 1.15 pF.

With the above-described arrangement and setting, this sixth embodiment realizes, as shown in Fig. 26, the band-pass type filter circuit having a wide frequency passband of 7 - 13 GHz.

Further, as in the first embodiment, conditions for generation of the attenuation pole can be easily determined by a theoretical analysis, and the position, etc. of the attenuation pole in the frequency characteristics of the filter circuit 100F can be adjusted by setting the constants of the impedance elements, etc. so as to satisfy the conditions.

A seventh embodiment of the present invention will be described below in relation to the case where the capacitor 124 and the transmission line 125, shown in Fig. 20, are employed as the distributed constant resonance circuit 113.

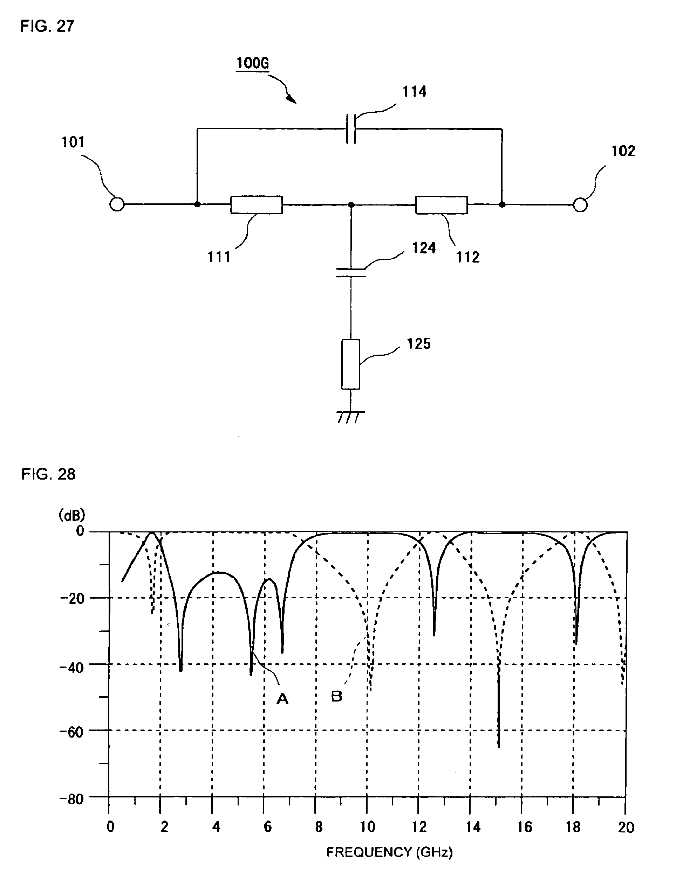

Fig. 27 is a diagram of a filter circuit according to the seventh embodiment of the present invention, and Fig. 28 is a graph showing frequency characteristics of the filter circuit according to the seventh embodiment. The seventh embodiment will be described in connection with a filter circuit which is adapted for realizing a band pass filter having a wide frequency passband of 7 - 12 GHz.

A filter circuit 100G shown in Fig. 27 comprises a first impedance element 111 having an input end connected to an input terminal 101, a second impedance element 112 having an input end connected to an output end of the first impedance element 111 and an output end connected to an output terminal 102 and made of the same component as that of the first impedance element 111, a capacitor 124 having one end connected to a junction between the output end of the first impedance element 111 and the input end of the second impedance element 112, a transmission line 125 having one end connected to the other end of the capacitor 124 and the other end grounded, and a third impedance element 114 having one end connected to the input end of the first impedance element 111 and the other end connected to the output end of the second impedance element 112.

In the seventh embodiment, the first impedance element 111 and the second impedance element 112 are each made of a distributed constant resonance circuit constituted by a transmission line which has a predetermined distributed constant. The third impedance element 114 is made of a capacitor having a predetermined concentrated constant.

The filter circuit 100G of the seventh embodiment is also a band-pass type filter circuit realizing a wide band, and it has a very simple structure comprising one distributed-constant stub type resonance circuit, two transmission lines, and two capacitors.

In this seventh embodiment, each of the transmission lines constituting the first and second impedance elements 111, 112 has a characteristic impedance of 37 Ω and an electrical length of 30° at the frequency of 6 GHz. Of the transmission line 125 and the capacitor 124 both constituting the distributed constant resonance circuit 113, the transmission line 125 has a characteristic impedance of 40 Ω and an electrical length of 180° at the frequency of 6 GHz, and the capacitor 124 has a capacitance of 2 pF. The capacitor constituting the third impedance element 114 has a capacitance of 0.65 pF.

With the above-described arrangement and setting, this seventh embodiment realizes, as shown in Fig. 28, the band-pass type filter circuit having a wide frequency passband of 7 - 12 GHz.

Further, as in the first embodiment, conditions for generation of the attenuation pole can be easily determined by a theoretical analysis, and the position, etc. of the attenuation pole in the frequency characteristics of the filter circuit 100G can be adjusted by setting the constants of the impedance elements, etc. so as to satisfy the conditions.

An eighth embodiment of the present invention will be described below in relation to the case where the transmission lines 126 and 127, shown in Fig. 21, are employed as the distributed constant resonance circuit 113.

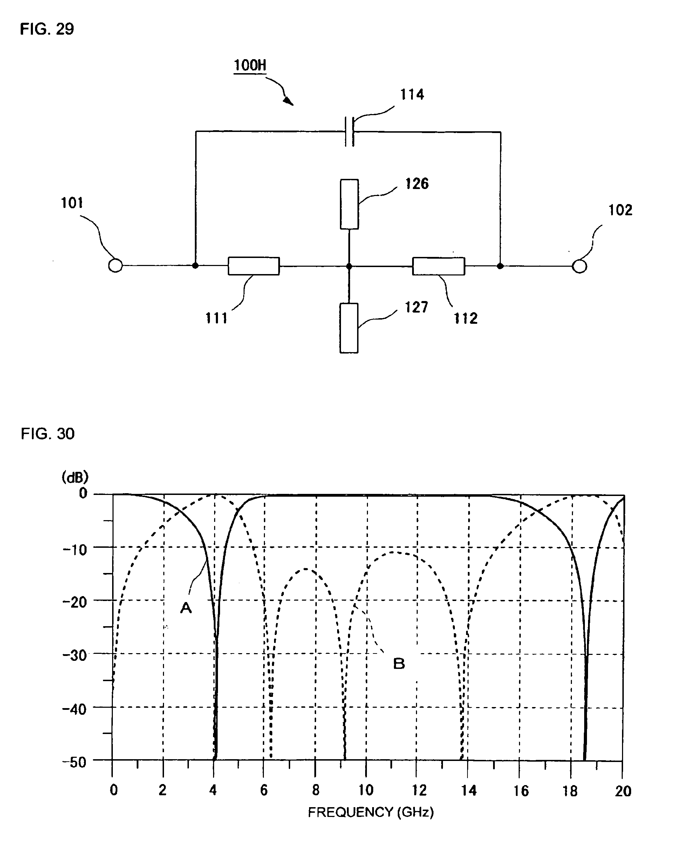

Fig. 29 is a diagram of a filter circuit according to the eighth embodiment of the present invention, and Fig. 30 is a graph showing frequency characteristics of the filter circuit according to the eighth embodiment. The eighth embodiment will be described in connection with a filter circuit which is adapted for realizing a band pass filter having a wide frequency passband of 4 - 18 GHz.

A filter circuit 100H shown in Fig. 29 comprises a first impedance element 111 having an input end connected to an input terminal 101, a second impedance element 112 having an input end connected to an output end of the first impedance element 111 and an output end connected to an output terminal 102 and made of the same component as that of the first impedance element 111, two transmission lines 126 and 127 each of which has one end connected to a junction between the output end of the first impedance element 111 and the input end of the second impedance element 112 and has the other end being opened, and a third impedance element 114 having one end connected to the input end of the first impedance element 111 and the other end connected to the output end of the second impedance element 112.

In the eighth embodiment, the first impedance element 111 and the second impedance element 112 are each made of a distributed constant resonance circuit constituted by a transmission line which has a predetermined distributed constant. The third impedance element 114 is made of a capacitor having a predetermined concentrated constant.

The filter circuit 100H of the eighth embodiment is also a band-pass type filter circuit realizing a wide band, and it has a very simple structure comprising two distributed-constant stub type resonance circuits, two transmission lines, and one capacitor.

In this eighth embodiment, each of the transmission lines constituting the first and second impedance elements 111, 112 has a characteristic impedance of 45 Ω and an electrical length L1 of 18° at the frequency of 2 GHz. Of the transmission lines 126 and 127 constituting the distributed constant resonance circuit 113, the transmission line 126 has a characteristic impedance of 50 Ω and an electrical length L2 of 45° at the frequency of 2 GHz, and the transmission line 127 has a characteristic impedance of 50 Ω and an electrical length L3 of 135° (= 180° - L2) at the frequency of 2 GHz. The capacitor constituting the third impedance element 114 has a capacitance of 1 pF.

With the above-described arrangement and setting, this sixth embodiment realizes, as shown in Fig. 30, the band-pass type filter circuit having a wide frequency passband of 4 - 18 GHz.

Further, as in the first embodiment, conditions for generation of the attenuation pole can be easily determined by a theoretical analysis, and the position, etc. of the attenuation pole in the frequency characteristics of the filter circuit 100H can be adjusted by setting the constants of the impedance elements, etc. so as to satisfy the conditions.

A ninth embodiment of the present invention will be described below in relation to the case where the transmission lines 128 and 129, shown in Fig. 22, are employed as the distributed constant resonance circuit 113.

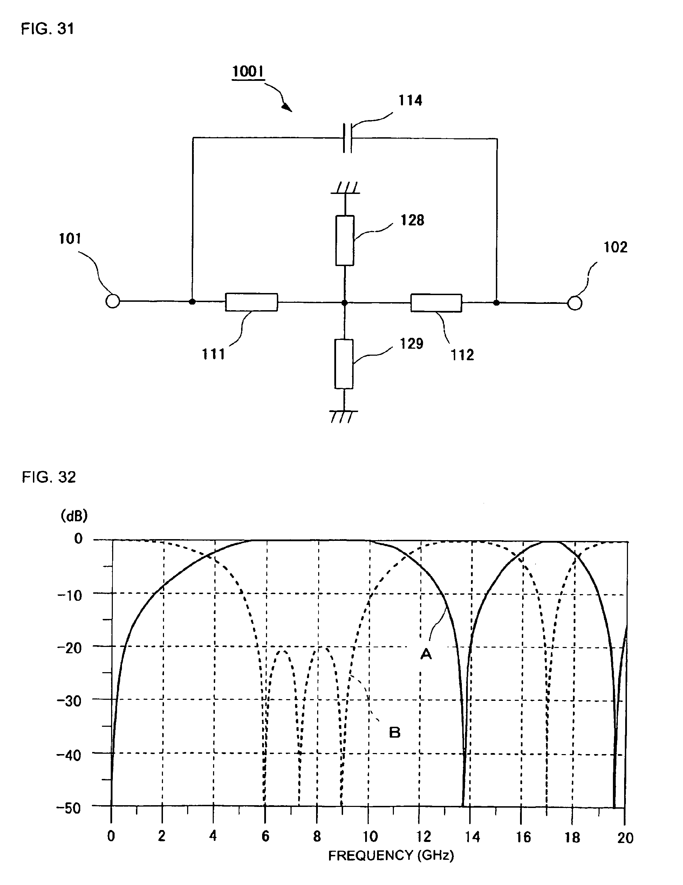

Fig. 31 is a diagram of a filter circuit according to the ninth embodiment of the present invention, and Fig. 32 is a graph showing frequency characteristics of the filter circuit according to the ninth embodiment. The ninth embodiment will be described in connection with a filter circuit which is adapted for realizing a band pass filter having a wide frequency passband of 1 - 13 GHz.

A filter circuit 100I shown in Fig. 31 comprises a first impedance element 111 having an input end connected to an input terminal 101, a second impedance element 112 having an input end connected to an output end of the first impedance element 111 and an output end connected to an output terminal 102 and made of the same component as that of the first impedance element 111, two transmission lines 128 and 129 each of which has one end connected to a junction between the output end of the first impedance element 111 and the input end of the second impedance element 112 and has the other end being grounded, and a third impedance element 114 having one end connected to the input end of the first impedance element 111 and the other end connected to the output end of the second impedance element 112.

In the ninth embodiment, the first impedance element 111 and the second impedance element 112 are each made of a distributed constant resonance circuit constituted by a transmission line which has a predetermined distributed constant. The third impedance element 114 is made of a capacitor having a predetermined concentrated constant.

The filter circuit 100I of the ninth embodiment is also a band-pass type filter circuit realizing a wide band, and it has a very simple structure comprising two distributed-constant stub type resonance circuits, two transmission lines, and one capacitor.

In this ninth embodiment, each of the transmission lines constituting the first and second impedance elements 111, 112 has a characteristic impedance of 45 Ω and an electrical length L1 of 18° at the resonance frequency of 6 GHz.

Of the transmission lines 128 and 129 constituting the distributed constant resonance circuit 113, the transmission line 128 has a characteristic impedance of 30 Ω and an electrical length L2 of 45° at the frequency of 6 GHz, and the transmission line 129 has a characteristic impedance of 60 Ω and an electrical length L3 of 135° (= 180° - L2) at the frequency of 6 GHz. The capacitor constituting the third impedance element 114 has a capacitance of 0.6 pF.

With the above-described arrangement and setting, this ninth embodiment realizes, as shown in Fig. 32, the band-pass type filter circuit having a wide frequency passband of 1 - 13 GHz.

Further, as in the first embodiment, conditions for generation of the attenuation pole can be easily determined by a theoretical analysis, and the position, etc. of the attenuation pole in the frequency characteristics of the filter circuit 100I can be adjusted by setting the constants of the impedance elements, etc. so as to satisfy the conditions.

As described above, the filter circuits according to the foregoing embodiments are very useful filter circuits which can realize an "ultra wide band characteristic", a "multiple attenuation-pole characteristic", and a "harmonic resonance suppression characteristic" by proper setting of the element values.

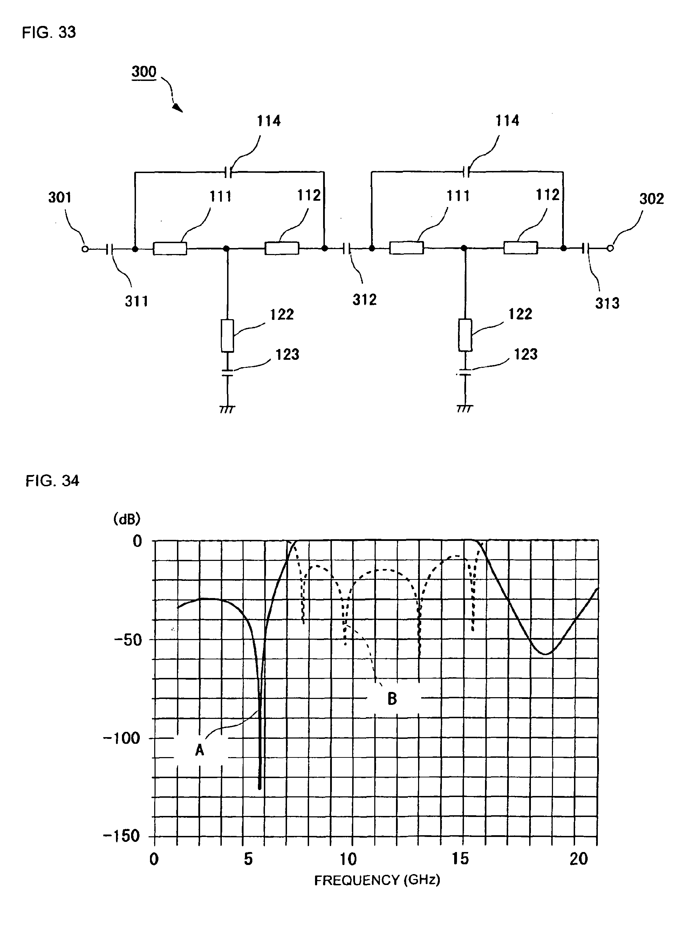

Further, it is possible to constitute a BPF (Band Pass Filter) by connecting two or more sets among the filter circuits 100 - 100I in series. For example, in a tenth embodiment of Fig. 33, a BPF 300 is constituted by connecting two sets of filter circuits 100F between an input terminal 301 and an output terminal 302 in series with capacitors 311-313 interposed as shown.

Fig. 34 shows frequency characteristics of the BPF 300. In Fig. 34, a curve A represents an attenuation characteristic curve, and a curve B represents a reflection characteristic curve. Also, the vertical axis represents amounts [dB] of attenuation and reflection, and the horizontal axis represents frequency [GHz]. As seen from the attenuation characteristic curve A, the amount of attenuation is maximized at 4.8 GHz and 17.5 GHz. As seen from the reflection characteristic curve B, the amount of reflection is minimized at 6.7 GHz, 8.6 GHz, 12.0 GHz and 14.3 GHz. The filter circuit 300 is designed to have a passband of 6 - 10 GHz.

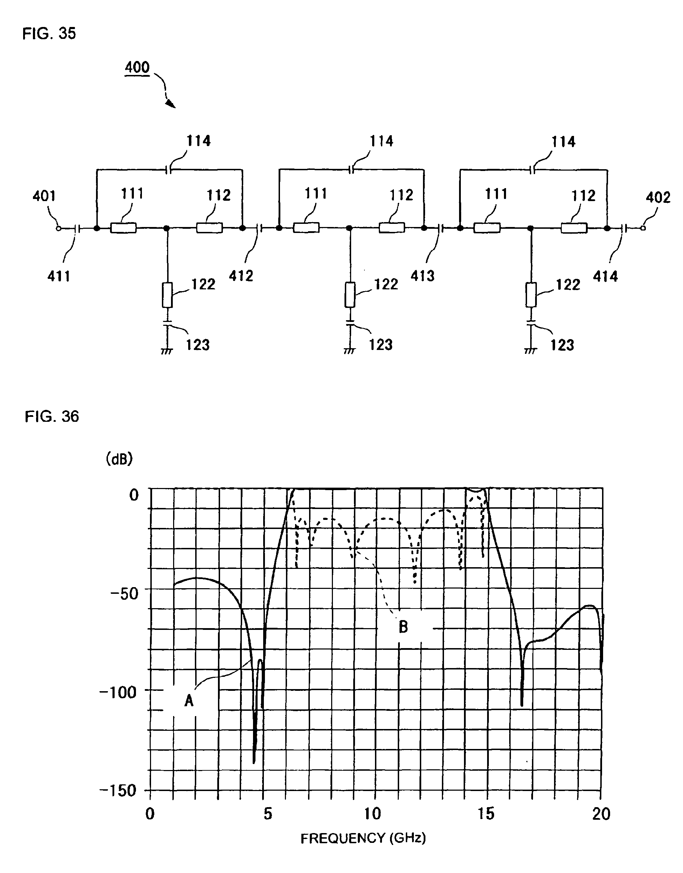

In an eleventh embodiment of Fig. 35, a BPF 400 is constituted by connecting three sets of filter circuits 100F between an input terminal 401 and an output terminal 402 in series with capacitors 411-414 interposed as shown.

Fig. 36 shows frequency characteristics of the BPF 400. In Fig. 36, a curve A represents an attenuation characteristic curve, and a curve B represents a reflection characteristic curve. Also, the vertical axis represents amounts [dB] of attenuation and reflection, and the horizontal axis represents frequency [GHz]. As seen from the attenuation characteristic curve A, the amount of attenuation is maximized at 4.5 GHz, 5.0 GHz, 16.5 GHz and 20.0 GHz. As seen from the reflection characteristic curve B, the amount of reflection is minimized at 6.3 GHz, 7.0 GHz, 9.0 GHz, 11.8 GHz, 13.8 GHz and 14.8 GHz. The filter circuit 400 is designed to have a passband of 6 - 15 GHz.

Thus, a BPF having superior frequency characteristics can be constituted by connecting two or more sets of the above-described filter circuits 100 - 100I in series with capacitors interposed therebetween.

Further, a filter circuit, a diplexer circuit, etc. realizing desired characteristics and shapes can be obtained by changing combinations of the above-described filter circuits and connections between them.

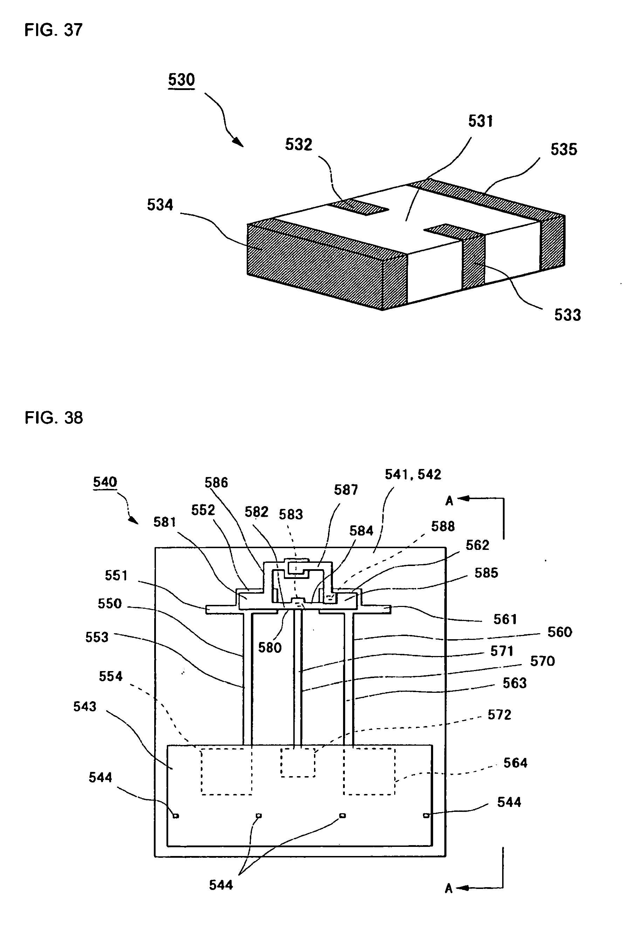

Fig. 37 shows, as a twelfth embodiment, an external appearance of a filter circuit device 530 that is obtained by forming the filter circuit 100 as one unit of device. More specifically, the filter circuit device 530 is constituted such that the filter circuit 100 is formed in a multilayered structure within a rectangular parallelepiped multilayered member 531 which is mainly made of a dielectric ceramic, and external terminal electrodes 532-535 are formed on an outer surface of the multilayered member 531. The external terminal electrode 532 corresponds to the input terminal 101, and the external terminal electrode 533 corresponds to the output terminal 102. Also, the external terminal electrodes 534 and 535 are grounded terminals.

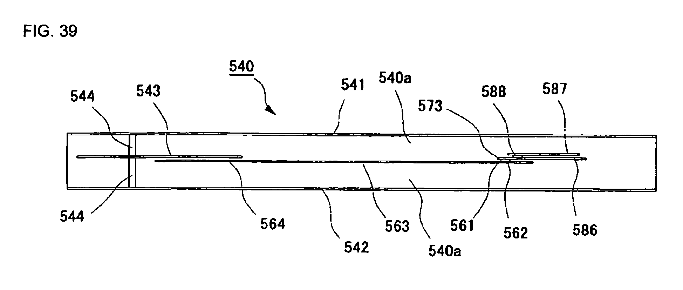

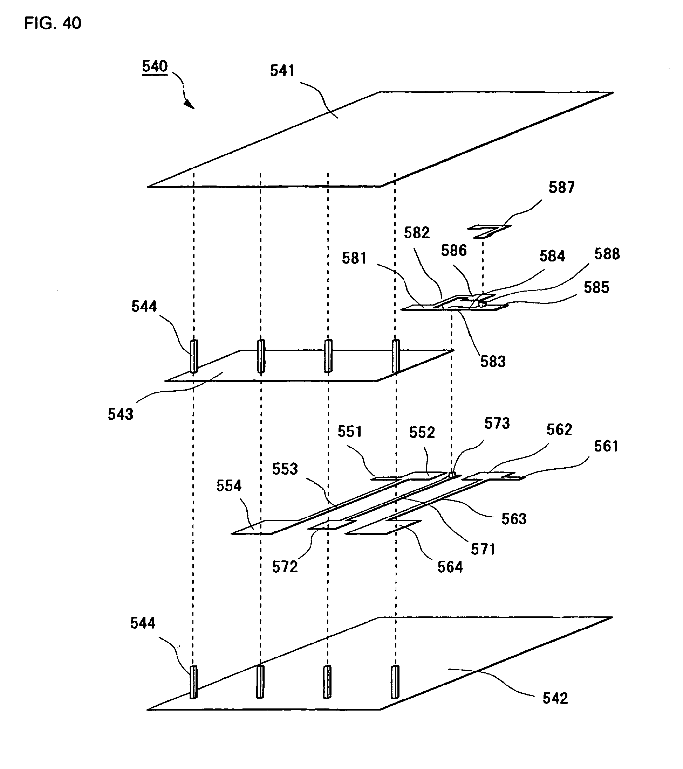

Figs. 38-40 illustrate shapes and layouts of conductor patterns in the case where another example of a BPF employing the above-described filter circuit 100F is formed inside a multilayered circuit board. Specifically, Fig. 38 is a layout view looking, from above, only conductor patterns of a filter circuit device having a modified circuit in which filter circuits are added to the upstream and downstream sides in the twelfth embodiment. Fig. 39 illustrates layout of electrodes and layout of via conductors 544 in a state resulting from adding a ceramic multilayered substrate to the conductor patters, shown in Fig. 38, in a way seeing through the interior from the right side indicated by A-A (Fig. 38) instead of viewing it taken along a cross-section. Fig. 40 is an exploded perspective view for explaining, in a disassembled form, positional relationships among only the conductor patterns shown in Fig. 38.

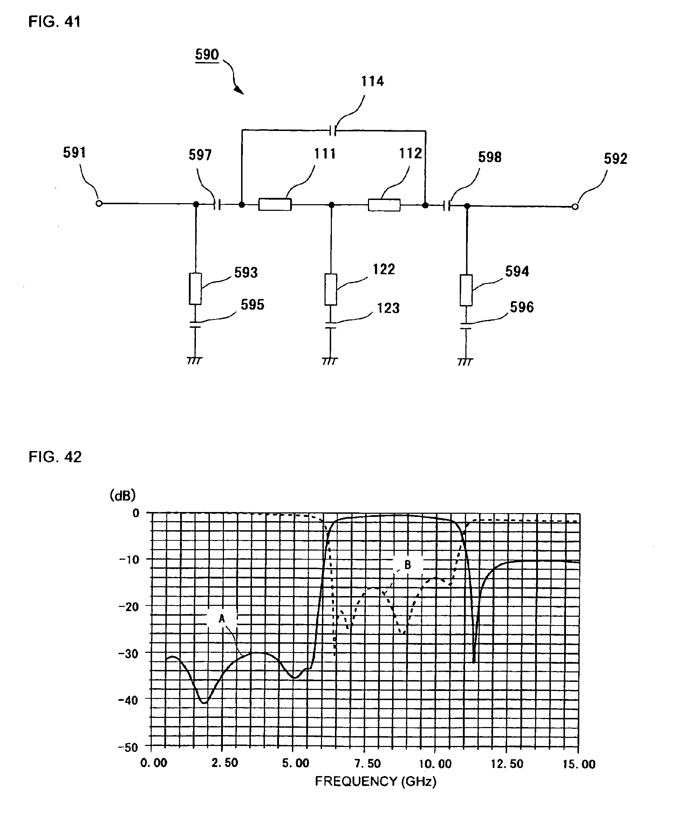

In Figs. 38-40, numeral 540 denotes a multilayered circuit board which is mainly made of a dielectric ceramic 540a and in which a plurality of conductor patterns are arranged in a multilayered structure to form a later-described filter circuit 590 shown in Fig. 41 (modification of Fig. 25). More specifically, in an area of the multilayered circuit board 540 where the filter circuit 590 is formed, grounded conductor patterns 541 and 542 parallel to each other are arranged respectively on a front surface and a rear surface. Other grounded conductor patterns 543 each having a predetermined size are disposed between and parallel to the grounded conductor patterns 541 and 542. The grounded conductor patterns 543 are connected to the grounded conductor patterns 541 and 542 for electrical conduction through a plurality of via conductors 544. Further, an input-side conductor pattern 550, an output-side conductor pattern 560, a resonance conductor pattern 570, and a connecting conductor pattern 580 are disposed between the grounded conductor patterns 541 and 542.

The input-side conductor pattern 550 is disposed parallel to the grounded conductor patterns 541 and 542, and it constitutes a second main resonance portion comprising an input-side strip line 551, a capacitor electrode 552 connected to the input-side conductor pattern 550 and constituting a second capacitor portion, a strip line 553 having one end connected to the capacitor electrode 552, and a capacitor electrode 554 connected to the other end of the strip line 553. Herein, only the capacitor electrode 554 is arranged to face the grounded conductor pattern 543.

The output-side conductor pattern 560 is disposed parallel to the grounded conductor patterns 541 and 542 in the same plane as the input-side conductor pattern 550, and it constitutes a third main resonance portion comprising an output-side strip line 561, a capacitor electrode 562 connected to the output-side conductor pattern 560 and constituting a third capacitor portion, a strip line 563 having one end connected to the capacitor electrode 562 and arranged parallel to the strip line 553, and a capacitor electrode 564 connected to the other end of the strip line 563. Herein, only the capacitor electrode 564 is arranged to face the grounded conductor pattern 543.

The resonance conductor pattern 570 is disposed between the input-side conductor pattern 550 and the output-side conductor pattern 560 in the same plane as them, and it constitutes a first main resonance portion comprising a strip line 571 arranged parallel to the strip line 553 and a capacitor electrode 572 connected to the other end of the strip line 571. Herein, only the capacitor electrode 572 is arranged to face the grounded conductor pattern 543.

The connecting conductor pattern 580 is arranged in a layer differing from a layer in which the input-side conductor pattern 550, the output-side conductor pattern 560 and the resonance conductor pattern 570 are arranged, with the dielectric ceramic 540a interposed between those two layers. The connecting conductor pattern 580 comprises an integral conductor pattern and a capacitor electrode 587. The integral conductor patter is made up of a capacitor electrode 581 which is arranged to face the capacitor electrode 552 and constitutes the second capacitor portion, a capacitor electrode 585 which is arranged to face the capacitor electrode 562 and constitutes the third capacitor portion, a strip line 582 having one end connected to the capacitor electrode 581, a connecting electrode 583 connected to the other end of the strip line 582, a strip line 584 having one end connected to the connecting electrode 583 and the other end connected to the capacitor electrode 585, and a capacitor electrode 586 which is connected to the capacitor electrode 581 and constitutes the first capacitor portion. The capacitor electrode 587 has one open end arranged to face an open end of the capacitor electrode 586 with the dielectric ceramic 540a interposed between them and the other end connected to the capacitor electrode 585 through a via conductor 588, and it constitutes the first capacitor portion. Further, the connecting electrode 583 is connected to one end of the strip line 571 through a via conductor 573.

Fig. 41 shows an equivalent circuit of the filter circuit device formed inside the multilayered circuit board 540. In the above-described structure, components of the equivalent circuit shown in Fig. 41 are constituted as follows.

A transmission line 593 connected to an input terminal 591 is constituted by the strip line 553, a capacitor 597 is constituted by the capacitor electrode 552 and the capacitor electrode 581, and a transmission line 111 is constituted by the strip line 582.

Also, a transmission line 594 connected to an output terminal 592 is constituted by the strip line 563, a capacitor 598 is constituted by the capacitor electrode 562 and the capacitor electrode 585, and a transmission line 112 is constituted by the strip line 584.

The main resonance portion comprising a transmission line 122 and a capacitor 123 is constituted by the strip line 571, the capacitor electrode 572, and the grounded conductor pattern 543.

A capacitor 114 connected between an input end of the input-side transmission line 111 and an output end of the output-side transmission line 112 is constituted by the capacitor electrode 586 and the capacitor electrode 587 arranged to face the former.

In addition, a serial resonance circuit connected to the input terminal 591 and comprising the transmission line 593 and the capacitor 595 is constituted by the strip line 553, the capacitor electrode 554, and the grounded conductor patterns 543. A serial resonance circuit connected to the output terminal 592 and comprising the transmission line 594 and the capacitor 596 is constituted by the strip line 563, the capacitor electrode 564, and the grounded conductor patterns 543.

Fig. 42 shows frequency characteristics of the filter circuit (band pass filter) 590 that is formed in the multilayered circuit board 540 as described above. In Fig. 42, a curve A represents an attenuation characteristic curve, and a curve B represents a reflection characteristic curve. Also, the vertical axis represents amounts [dB] of attenuation and reflection, and the horizontal axis represents frequency [GHz]. As seen from the attenuation characteristic curve A, the amount of attenuation is maximized at 1.8 GHz, 5.2 GHz and 11.3 GHz. As seen from the reflection characteristic curve B, the amount of reflection is minimized at 6.5 GHz, 7.0 GHz, 8.8 GHz and 10.5 GHz. The filter circuit 590 is designed to have a passband of 6 - 11 GHz on the basis of the above-described filter circuit 100F.

Additionally, the filter circuit device 530 shown in Fig. 37 can be constructed by removing the strip lines 551 and 553 and the capacitor electrode 554 of the input-side conductor pattern 550 and the strip lines 561 and 563 and the capacitor electrode 564 of the output-side conductor pattern 560, which are shown in Figs. 38-40.

As seen from the above description, the filter circuit of the present invention can be realized in a very small structure in the case using an LTCC (Low Temperature Co-fired Ceramics) substrate, an LTCC device, or the like in which a capacitor can be easily fabricated.

A thirteenth embodiment of the present invention will be described below.

In the thirteenth embodiment, a high-frequency wireless circuit module is constructed which includes a band pass filter (BPF) using the above-described filter circuit.

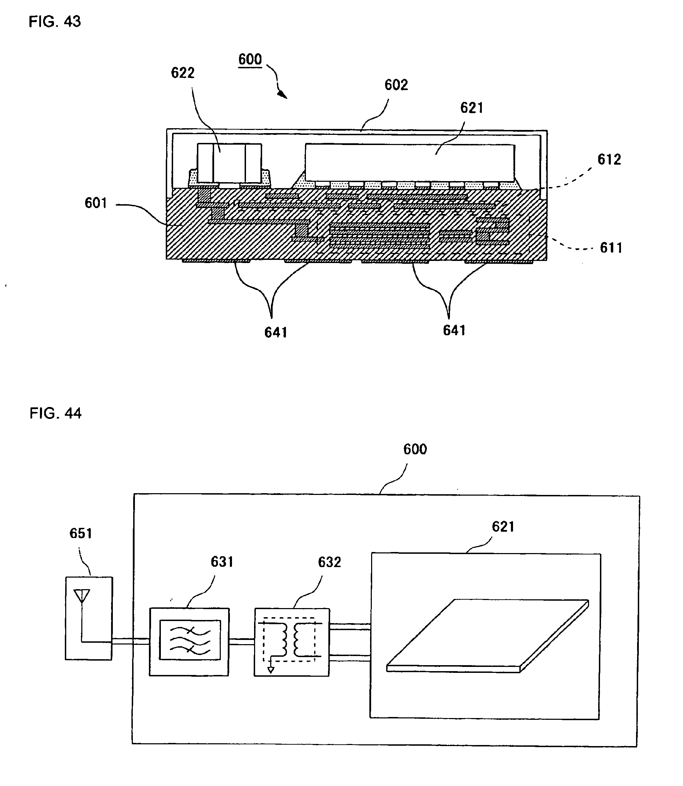

Figs. 43 and 44 illustrate the thirteenth embodiment of the present invention. More specifically, Fig. 43 is a side view showing, in a seeing-through way, the high-frequency wireless circuit module according to the thirteenth embodiment of the present invention, and Fig. 44 is a block diagram showing an electric circuit of the high-frequency wireless circuit module according to the thirteenth embodiment of the present invention.

In Fig. 43, numeral 600 denotes the high-frequency wireless circuit module in which electronic parts, such as an IC 621 and a passive element 622 both constituting a wireless transmit/receive function section (wireless function section), are mounted on a module substrate 601 that is made of a ceramic substrate, e.g., an LTCC (Low Temperature Co-fired Ceramics) substrate, or a resin substrate. Further, an upper surface of the module substrate 601 is covered with a shield member 602. The module substrate 601 includes therein conductor pattern electrodes 611 forming a band pass filter (BPF) 631, and conductor pattern electrodes 612 forming a balun 632. A circuit thus constituted can be connected to an external circuit through a plurality of external electrodes 641 which are formed on a bottom surface of the module substrate 601.

As shown in Fig. 44, the electric circuit of the high-frequency wireless circuit module 600 comprises the IC 621, the band pass filter (BPF) 631, and the balun 632. The input side of the band pass filter (BPF) 631 is connected to an external antenna 651 through the external electrode 641. The output side of the band pass filter (BPF) 631 is connected, inside the module substrate 601, to the input side of the balun 621, and the output side of the balun 621 is connected, inside the module substrate 601, to the IC 621 which constitutes the wireless transmit/receive function section (wireless function section).

In the high-frequency wireless circuit module 600 of the thirteenth embodiment, similarly to the above-described embodiments, the band pass filter (BPF) 631 employing the filter circuit of the present invention can also be formed in a very small structure. Therefore, the high-frequency wireless circuit module 600 including the band pass filter (BPF) 631 can be obtained in a small size.

It is to be noted that the above-described embodiments merely illustrate several practical examples and the present invention is not limited to only the constructions of the above-described embodiments. The present invention can be variously modified without departing from the scope of the invention. Examples of the modifications are as follows:

1) While the present invention has been described in connection with practical examples in which the filter circuit is formed in the multilayered circuit board, a filter circuit device can also be obtained by forming, on one dielectric substrate, impedance elements, e.g., strip lines, and an open stub type resonance circuit in the form of a distributed constant resonance circuit in combination with discrete parts, such as a capacitor and an inductor. Although such a filter circuit device requires design in consideration of a wiring pattern, the objective filter circuit device can be provided once a circuit configuration is decided.
2) The present invention can also be implemented in the form of a circuit module in which the filter circuit device described in the above item 1) is integrated with a circuit board including discrete parts, such as an IC module, a capacitor, and an inductor, in a combined manner.
3) While a practical example of the distributed constant resonance circuit has been described only as a strip line, other types of distributed constant resonance circuit elements, e.g., a micro-strip line, a slot line, and a coplanar web guide, can also be used as a matter of course, and the objective filter circuit device can be provided once a circuit configuration is decided.

**Claims**

**1.** A band pass filter circuit comprising:

a first impedance element (111) disposed in an input side;
a second impedance element (112) disposed in an output side, having an input end connected to an output end of the first impedance element, and made of the same component as that of the first impedance element;
a distributed constant resonance circuit (113) having one end connected to a junction between the output end of the first impedance element and the input end of the second impedance element; and
a third impedance element (114) having one end connected to the input end of the first impedance element and the other end connected to the output end of the second impedance element,
wherein at least one of the first to third impedance elements is constituted by an element having a predetermined concentrated constant, and the other impedance elements are each constituted by an element having a predetermined distributed constant.

2. The band pass filter circuit according to Claim 1, wherein the first impedance element and the second Impedance element are each made of a transmission line having a predetermined distributed constant, wherein the distributed constant resonance circuit is made of an open stub type resonance circuit constituted by a transmission line which has a predetermined distribution constant and is opened at the other end of the distributed constant resonance circuit, and wherein the third impedance element is made of a capacitor.

3. The band pass filter circuit according to Claim 1, wherein the first impedance element and the second impedance element are each made of an inductor, wherein the distributed constant resonance circuit is made of an open stub type resonance circuit constituted by a transmission line which has a predetermined distribution constant and is opened at the other end of the distributed constant resonance circuit, and wherein the third impedance element is made of a capacitor.

4. The band pass filter circuit according to Claim 1, wherein the first impedance element and the second impedance element are each made of a capacitor, wherein the distributed constant resonance circuit is made of an open stub type resonance circuit constituted by a transmission line which has a predetermined distribution constant and is opened at the other end of the distributed constant resonance circuit, and wherein the third impedance element is made of a transmission line.

5. The band pass filter circuit according to Claim 1, wherein the first impedance element and the second impedance element are each made of a capacitor, wherein the distributed constant resonance circuit is made of an open stub type resonance circuit constituted by a transmission line which has a predetermined distribution constant and is opened at the other end of the distributed constant resonance circuit, and wherein the third impedance element is made of an inductor.

6. The band pass filter circuit according to Claim 1, wherein the distributed constant resonance circuit is made of one or more open stub type resonance circuits each constituted by a transmission line which has a predetermined distribution constant and is opened at the other end of the distributed constant resonance circuit.

7. The band pass filter circuit according to Claim 1, wherein the distributed constant resonance circuit is made of one or more short stub type resonance circuits each constituted by a transmission line which has a predetermined distribution constant and is grounded at the other end of the distributed constant resonance circuit.

8. The band pass filter circuit according to Claim 1, wherein the distributed constant resonance circuit is constituted by serial connection of a stub type resonance circuit constituted by a transmission line which has a predetermined distribution constant, and a capacitor.

9. A band pass filter circuit device wherein the band pass filter circuit according to any one of Claims 1 to 8 is formed in a device member constituting a device body.

10. A multilayered circuit board in which the band pass filter circuit according to any one of Claims 1 to 8 is formed.

11. A circuit module in which the band pass fitter circuit according to any one of Claims 1 to 8 is formed.

**Patentansprüche**

1. Bandpassfilterschaltung, umfassend:

   ein in einer Eingangsseite angeordnetes erstes Impedanzelement (111);
   ein in einer Ausgangsseite angeordnetes zweites Impedanzelement (112) mit einem Eingangsende, das mit einem Ausgangsende des ersten Impedanzelements verbunden ist, und das aus derselben Komponente wie der des ersten Impedanzelements besteht;

eine Resonanzschaltung (113) mit verteilter Konstante mit einem Ende, das mit einem Knoten zwischen dem Ausgangsende des ersten Impedanzelements und dem Eingangsende des zweiten Impedanzelements verbunden ist; und

ein drittes Impedanzelement (114) mit einem Ende, das mit dem Eingangsende des ersten Impedanzelements verbunden ist, und das andere Ende ist mit dem Ausgangsende des zweiten Impedanzelements verbunden, wobei mindestens eines des ersten bis dritten Impedanzelements durch ein Element dargestellt wird, das eine vorbestimmte konzentrierte Konstante aufweist, und die anderen Impedanzelemente jeweils durch ein Element dargestellt werden, das eine vorbestimmte verteilte Konstante aufweist.

2. Bandpassfilterschaltung nach Anspruch 1, wobei das erste Impedanzelement und das zweite Impedanzelement jeweils aus einer Übertragungsleitung bestehen, die eine vorbestimmte verteilte Konstante aufweist, wobei die Resonanzschaltung mit verteilter Konstante aus einer Resonanzschaltung des offenen Blindleitungstyps besteht, die durch eine Übertragungsleitung dargestellt wird, die eine vorbestimmte Verteilungskonstante aufweist und an dem anderen Ende der Resonanzschaltung mit verteilter Konstante geöffnet ist, und wobei das dritte Impedanzelement aus einem Kondensator besteht.

3. Bandpassfilterschaltung nach Anspruch 1, wobei das erste Impedanzelement und das zweite Impedanzelement jeweils aus einer Induktivität bestehen, wobei die Resonanzschaltung mit verteilter Konstante aus einer Resonanzschaltung des offenen Blindleitungstyps besteht, die durch eine Übertragungsleitung dargestellt wird, die eine vorbestimmte Verteilungskonstante aufweist und an dem anderen Ende der Resonanzschaltung mit verteilter Konstante geöffnet ist, und wobei das dritte Impedanzelement aus einem Kondensator besteht.

4. Bandpassfilterschaltung nach Anspruch 1, wobei das erste Impedanzelement und das zweite Impedanzelement jeweils aus einem Kondensator bestehen, wobei die Resonanzschaltung mit verteilter Konstante aus einer Resonanzschaltung des offenen Blindleitungstyps besteht, die durch eine Übertragungsleitung dargestellt wird, die eine vorbestimmte Verteilungskonstante aufweist und an dem anderen Ende der Resonanzschaltung mit verteilter Konstante geöffnet ist, und wobei das dritte Impedanzelement aus einer Übertragungsleitung besteht.

5. Bandpassfilterschaltung nach Anspruch 1, wobei das erste Impedanzelement und das zweite Impedanzelement jeweils aus einem Kondensator bestehen, wobei die Resonanzschaltung mit verteilter Konstante aus einer Resonanzschaltung des offenen Blindleitungstyps besteht, die durch eine Übertragungsleitung dargestellt wird, die eine vorbestimmte Verteilungskonstante aufweist und an dem anderen Ende der Resonanzschaltung mit verteilter Konstante geöffnet ist, und wobei das dritte Impedanzelement aus einer Induktivität besteht.

6. Bandpassfilterschaltung nach Anspruch 1, wobei die Resonanzschaltung mit verteilter Konstante aus einer oder mehreren Resonanzschaltungen des offenen Blindleitungstyps besteht, die jeweils durch eine Übertragungsleitung dargestellt werden, die eine vorbestimmte Verteilungskonstante aufweist und an dem anderen Ende der Resonanzschaltung mit verteilter Konstante geöffnet ist.

7. Bandpassfilterschaltung nach Anspruch 1, wobei die Resonanzschaltung mit verteilter Konstante aus einer oder mehreren Resonanzschaltungen des kurzen Blindleitungstyps besteht, die jeweils durch eine Übertragungsleitung dargestellt werden, die eine vorbestimmte Verteilungskonstante aufweist und an dem anderen Ende der Resonanzschaltung mit verteilter Konstante mit Masse verbunden ist.

8. Bandpassfilterschaltung nach Anspruch 1, wobei die Resonanzschaltung mit verteilter Konstante durch eine serielle Verbindung einer Resonanzschaltung des Blindleitungstyps dargestellt wird, die durch eine Übertragungsleitung, die eine vorbestimmte Verteilungskonstante aufweist, und einen Kondensator dargestellt wird.

9. Bandpassfilterschaltungseinrichtung, wobei die Bandpassfilterschaltung nach einem der Ansprüche 1 bis 8 in einem Einrichtungsglied, das einen Einrichtungskörper darstellt, gebildet ist.

10. Mehrschichtige Leiterplatte, in der die Bandpassfilterschaltung nach einem der Ansprüche 1 bis 8 gebildet ist.

11. Schaltungsmodul, in dem die Bandpassfilterschaltung nach einem der Ansprüche 1 bis 8 gebildet ist.

**Revendications**

1. Circuit de filtre passe-bande comprenant :

   un premier élément d'impédance (111) disposé dans un côté d'entrée ;
   un deuxième élément d'impédance (112) disposé dans un côté de sortie, ayant une extrémité d'entrée connectée à une extrémité de sortie du premier élément d'impédance, et consistant en le même composant que celui du premier élément d'impédance ;
   un circuit de résonance à constante distribuée (113) ayant une extrémité connectée à une jonction entre l'extrémité de sortie du premier élément d'impédance et l'extrémité d'entrée du deuxième élément d'impédance ; et
   un troisième élément d'impédance (114) ayant une extrémité connectée à l'extrémité d'entrée du premier élément d'impédance et l'autre extrémité connectée à l'extrémité de sortie du deuxième élément d'impédance ;
   dans lequel au moins l'un des premier au troisième éléments d'impédance est constitué par un élément ayant une constante concentrée prédéterminée, et les autres éléments d'impédance sont chacun constitués par un élément ayant une constante distribuée prédéterminée.

2. Circuit de filtre passe-bande selon la revendication 1, dans lequel le premier élément d'impédance et le deuxième élément d'impédance consistent chacun en une ligne de transmission ayant une constante distribuée prédéterminée, dans lequel le circuit de résonance à constante distribuée consiste en un circuit de résonance du type à stub en circuit ouvert constitué par une ligne de transmission qui a une constante de distribution prédéterminée et est ouverte à l'autre extrémité du circuit de résonance à constante distribuée, et dans lequel le troisième élément d'impédance consiste en un condensateur.

3. Circuit de filtre passe-bande selon la revendication 1, dans lequel le premier élément d'impédance et le deuxième élément d'impédance consistent chacun en une bobine d'inductance,
   dans lequel le circuit de résonance à constante distribuée consiste en un circuit de résonance du type à stub en circuit ouvert constitué par une ligne de transmission qui a une constante de distribution prédéterminée et est ouverte à l'autre extrémité du circuit de résonance à constante distribuée, et
   dans lequel le troisième élément d'impédance consiste en un condensateur.

4. Circuit de filtre passe-bande selon la revendication 1, dans lequel le premier élément d'impédance et le deuxième élément d'impédance consistent chacun en un condensateur,
   dans lequel le circuit de résonance à constante distribuée consiste en un circuit de résonance du type à stub en circuit ouvert constitué par une ligne de transmission qui a une constante de distribution prédéterminée et est ouverte à l'autre extrémité du circuit de résonance à constante distribuée, et
   dans lequel le troisième élément d'impédance consiste en un ligne de transmission.

5. Circuit de filtre passe-bande selon la revendication 1, dans lequel le premier élément d'impédance et le deuxième élément d'impédance consistent chacun en un condensateur,
   dans lequel le circuit de résonance à constante distribuée consiste en un circuit de résonance du type à stub en circuit ouvert constitué par une ligne de transmission qui a une constante de distribution prédéterminée et est ouverte à l'autre extrémité du circuit de résonance à constante distribuée, et
   dans lequel le troisième élément d'impédance consiste en une bobine d'inductance.

6. Circuit de filtre passe-bande selon la revendication 1, dans lequel le circuit de résonance à constante distribuée consiste en un ou plusieurs circuits de résonance du type à stub en circuit ouvert constitué par une ligne de transmission qui a une constante de distribution prédéterminée et est ouverte à l'autre extrémité du circuit de résonance à constante distribuée.

7. Circuit de filtre passe-bande selon la revendication 1, dans lequel le circuit de résonance à constante distribuée consiste en un ou plusieurs circuits de résonance du type à stub en circuit ouvert constitués chacun par une ligne de transmission qui a une constante de distribution prédéterminée et est mise à la masse à l'autre extrémité du circuit de résonance à constante distribuée.

8. Circuit de filtre passe-bande selon la revendication 1, dans lequel le circuit de résonance à constante distribuée est constitué par une connexion série d'un circuit de résonance du type à stub constitué par une ligne de transmission qui a une constante de distribution prédéterminée, et un condensateur.

**9.** Dispositif à circuit de filtre passe-bande dans lequel le circuit de filtre passe-bande selon l'une quelconque des revendications 1 à 8 est formé en un élément de dispositif constituant un corps de dispositif.

**10.** Carte de circuits multicouches dans laquelle le circuit de filtre passe-bande selon l'une quelconque des revendications 1 à 8 est formé.

**11.** Module de circuit dans lequel le circuit de filtre passe-bande selon l'une quelconque des revendications 1 à 8 est formé.

FIG. 1

FIG. 2

FIG. 3

FIG. 4

FIG. 5

$$100$$

FIG. 6

FIG. 7

FIG. 8

FIG. 9

FIG. 10

FIG. 11

FIG. 12

FIG. 13

FIG. 14

FIG. 15

FIG. 16

FIG. 17

FREQUENCY (GHz)

FIG. 18

121

FIG. 19

122

123

FIG. 20

124

125

FIG. 21

126

127

FIG. 22

128

129

FIG. 23

FIG. 24

FREQUENCY (GHz)

FIG. 25

100F

114

101

111

112

102

122

123

FIG. 26

(dB)

0

-20

-40

-60

-80

A

B

0    2    4    6    8    10    12    14    16    18    20

FREQUENCY (GHz)

FIG. 27

FIG. 28

FIG. 29

FIG. 30

FIG. 31

FIG. 32

FIG. 33

FIG. 34

FIG. 35

FIG. 36

FIG. 37

530

531

532

535

534

533

FIG. 38

540

586

582 583

587

541, 542

A

581

552

584

588

562

551

585

550

561

560

553

571

570

580

563

554

572

543

564

544

544

544

A

FIG. 39

540

544  543  541  540a  573  588  587

544

564  542  563  561  562  586  540a

FIG. 40

FIG. 41

FIG. 42

FIG. 43

FIG. 44

**REFERENCES CITED IN THE DESCRIPTION**

**Patent documents cited in the description**

- JP 2005295316 A
- JP 2005318428 A
- JP 2007068123 A
- JP 58190113 B
- JP 2005136836 B
- US 5202651 A